# EUROPÄISCHE PATENTSCHRIFT

(11) **EP 3 516 710 B1**
(45) Veröffentlichungstag und Bekanntmachung des Hinweises auf die Patenterteilung: **19.04.2023**
(21) Anmeldenummer: 17772672.6
(22) Anmeldetag: 20.09.2017
(51) Int. Cl.: H10K 85/10, H10K 50/15, H10K 50/16, H10K 50/844

(54) **DIFFUSIONSLIMITIERENDE ELEKTROAKTIVE BARRIERESCHICHT FÜR EIN OPTOELEKTRONISCHES BAUTEIL**
DIFFUSION-LIMITING ELECTROACTIVE BARRIER LAYER FOR AN OPTOELECTRONIC COMPONENT
COUCHE BARRIÈRE ÉLECTROACTIVE LIMITANT LA DIFFUSION POUR UN COMPOSANT OPTOÉLECTRONIQUE

(30) Priorität: 20.09.2016 DE 102016117697
(43) Veröffentlichungstag der Anmeldung: 31.07.2019
(73) Patentinhaber: INURU GmbH, 12489 Berlin (DE)
(72) Erfinder: RATAJCZAK, Marcin, 13353 Berlin (DE); BARKOWSKI, Patrick, 12459 Berlin (DE)
(74) Vertreter: Hertin und Partner Rechts- und Patentanwälte PartG mbB
(86) Internationale Anmeldenummer: PCT/EP2017/073753
(87) Internationale Veröffentlichungsnummer: WO 2018/054962

(56) Entgegenhaltungen:
- K. LEE ET AL: "Air-Stable Polymer Electronic Devices", ADVANCED MATERIALS, Bd. 19, Nr. 18, 17. September 2007 (2007-09-17), Seiten 2445-2449, XP055066191, ISSN: 0935-9648, DOI: 10.1002/adma.200602653
- EUNJUNG KANG ET AL: "Organic electroluminescent devices using poly(vinylidene fluoride-co-hexafluoropropylene) doped with triphenylamine derivative as a hole-transporting layer", PROCEEDINGS OPTICAL DIAGNOSTICS OF LIVING CELLS II, Bd. 3281, 17. April 1998 (1998-04-17), Seite 336, XP055418870, US ISSN: 0277-786X, DOI: 10.1117/12.305438 ISBN: 978-1-5106-1354-6
- DONG-HYUN LEE ET AL: "Polymer Organic Light-Emitting Devices with Cathodes Transferred under Ambient Conditions", JAPANESE JOURNAL OF APPLIED PHYSICS, JAPAN SOCIETY OF APPLIED PHYSICS, JP, Bd. 50, Nr. 11, 1. November 2011 (2011-11-01), Seiten 110206-1, XP001572487, ISSN: 0021-4922, DOI: 10.1143/JJAP.50.110206 [gefunden am 2011-10-26]
- HYO-MIN KIM ET AL: "Semi-transparent quantum-dot light emitting diodes with an inverted structure", JOURNAL OF MATERIALS CHEMISTRY C: MATERIALS FOR OPTICAL AND ELECTRONIC DEVICES, Bd. 2, Nr. 12, 6. Januar 2014 (2014-01-06) , Seite 2259, XP055418813, UK ISSN: 2050-7526, DOI: 10.1039/c3tc31932f
- JINGBI YOU ET AL: "Improved air stability of perovskite solar cells via solution-processed metal oxide transport layers", NATURE NANOTECHNOLOGY, Bd. 11, Nr. 1, 12. Oktober 2015 (2015-10-12), Seiten 75-81, XP055418753, GB ISSN: 1748-3387, DOI: 10.1038/nnano.2015.230
- ANAND S. SUBBIAH ET AL: "Inorganic Hole Conducting Layers for Perovskite-Based Solar Cells", JOURNAL OF PHYSICAL CHEMISTRY LETTERS, Bd. 5, Nr. 10, 15. Mai 2014 (2014-05-15), Seiten 1748-1753, XP055418761, US ISSN: 1948-7185, DOI: 10.1021/jz500645n
- DONG-HEE PARK ET AL: "Flexible Audible Display using ITO on PVDF and Its Interface Analysis", MRS PROCEEDINGS, Bd. 1116, 1. Januar 2008 (2008-01-01), XP055418864, DOI: 10.1557/PROC-1116-I02-03

## Beschreibung

Die Erfindung betrifft ein optoelektronisches Bauelement mit einer Kathode und einer Anode und einem Schichtsystem zwischen der Kathode und der Anode umfassend elektroaktive Schichten, insbesondere Ladungsträgerinjektions- und transportschichten sowie eine optisch aktive Schicht, wobei die Ladungsträgerinjektions- und transportschichten selbst eine Diffusionsbarriere gegenüber Wasser oder Sauerstoff darstellen.

### STAND DER TECHNIK UND HINTERGRUND

Die Erfindung betrifft das Gebiet von optoelektronischen Bauelementen. Optoelektronische Bauelemente, beispielsweise auf organischer Basis oder aber als hybride Bauelemente aus organischen und anorganischen Schichten, werden verbreitet in der Technologie eingesetzt.

Organische Leuchtdioden (OLEDs) bestehen zumeist aus einem Sandwich Aufbau, wobei sich zwischen zwei Elektroden zumeist mehrere Schichten organischer halbleitender Materialien befinden. Insbesondere umfasst eine OLED eine oder mehrere Emitterschichten (engl. *emitter layer* EL) in welcher oder in welchen elektromagnetische Strahlung, bevorzugt im sichtbaren Bereich, durch eine Rekombination von Elektronen mit Elektronenlöchern erzeugt wird. Die Elektronen und Elektronenlöcher werden durch jeweils eine Kathode bzw. Anode bereitgestellt, wobei bevorzugt sogenannte Injektionsschichten durch eine Absenkung der Injektionsbarriere den Prozess erleichtern. OLEDS verfügen daher zumeist über Elektronen- bzw. Lochinjektionsschichten. Des Weiteren verfügen OLEDs in der Regel über Elektronen- und Lochtransportschichten (engl. *hole transport layer* (HTL) oder *electron transport layer* (ETL)), welche die Diffusionsrichtung der Elektronen und Löcher zur Emitterschicht unterstützen. Bei OLEDs sind diese Schichten aus organischen Materialien aufgebaut, bei hybriden optoelektronischen Bauteilen können die Schichten teilweise aus organischen teilweise auch aus anorganischen Materialien bestehen.

Im Vergleich zu herkömmlichen anorganischen LEDs zeichnen sich OLEDs und hybride LEDs durch einen dünnen und flexiblen Schichtaufbau aus. Aus diesem Grunde lassen sich OLEDs und hybride LEDs deutlich vielfältiger als klassische anorganische LEDs einsetzen. Aufgrund der Biegsamkeit sind OLEDs beispielsweise für Bildschirme, elektronisches Papier oder die Innenbeleuchtung hervorragend einsetzbar.

Die vorteilhaften Eigenschaften optoelektronischer Bauelemente umfassend organisch halbleitenden Materialien zur Lichterzeugung (OLEDs oder hybride LEDs) lassen sich ebenso auf die Erzeugung von elektrischem Strom übertragen. So zeichnen sich organische Solarzellen oder hybride Solarzellen gleichfalls durch einen dünnen Schichtaufbau aus, welcher die Einsatzmöglichkeiten gegenüber klassischen anorganischen Solarzellen deutlich erhöht. Der Aufbau von organischen Solarzellen oder hybriden Solarzellen weist Ähnlichkeiten mit OLEDs oder hybriden LEDs auf.

Anstatt einer Emitterschicht liegen als photoaktive Schicht jedoch eine oder mehrere Absorberschichten vor. In der Absorberschicht werden aufgrund einfallender elektromagnetischer Strahlung Elektronen-Loch-Paare als freie Ladungsträger erzeugt. Die weiteren Schichten umfassen Elektronen- und Lochtransportschichten sowie Elektronenextraktions- und Lochextraktionsschichten. Diese bestehen aus organischen Materialien oder im Falle von hybriden aus organischen und anorganischen Materialien, deren elektrochemischen Potentiale derart als Donator- und Akzeptorschichten verschoben sind, dass diese in der Solarzelle ein internes Feld erzeugen, welches die freien Ladungsträger zu den Elektroden abführt. Durch den Einfall der elektromagnetischen Strahlung werden dadurch an der Kathode Elektronen und an der Anode Elektronenlöcher zur Erzeugung einer Spannung bzw. eines Stromes bereitgestellt.

Aufgrund des dünnen Schichtaufbaus lassen sich organische Solarzellen günstig herstellen und können als Folienbeschichtung weitflächig an Gebäuden angebracht werden

Weitere Anwendungsmöglichkeiten von optoelektronischen Bauelementen aus organischen oder anorganischen-organischen Schichten betreffen z.B. Fotodetektoren. Auch diese nutzen den Fotoeffekt aus, wobei in der photoaktiven Schicht Elektronen-Loch-Paare erzeugt werden. Anstatt zur Erzeugung von Strom, wie bei den Solarzellen, werden diese zur Detektion von Licht zum Beispiel für Kameras eingesetzt.

Der Dünnschichtaufbau der vorgenannten optoelektronischen Bauelemente erlaubt nicht nur einen deutlich flexibleren Einsatz im Alltag, sondern zeichnet sich im Vergleich zu den herkömmlichen LEDs, Solarzellen oder Fotodetektoren durch kostengünstige Herstellungsmöglichkeiten aus.

Ein Nachteil des Dünnschichtaufbaus ist hingegen eine zumeist geringere Lebensdauer dieser optoelektronischen Bauelemente im Vergleich zu herkömmlichen Aufbauten. Insbesondere führt eine Degradation durch Wasserdämpfe oder Sauerstoff an den elektronischen aktiven Schichten zu Abnutzungserscheinung und einem abnehmenden Wirkungskoeffizienten. Im Gegensatz zu herkömmlichen Aufbauten werden die Dünnschichtaufbauten nicht durch Glas oder andere Wasser oder Sauerstoff resistente Materialien abgedeckt. Auch sind die chemischen Kohlenwasserstoffverbindungen der organischen oder hybriden Bauelemente anfälliger gegenüber chemischen oder physikalischen Degradationsprozessen.

Aus diesem Grunde werden im bekannten Stand der Technik verschiedenste Techniken zur Verkapselung der optoelektronischen Bauelemente eingesetzt, um eine Permeation von schädigenden Wasserdämpfen oder eine Oxidation durch Sauerstoff zu vermeiden.

Beispielsweise wird in der WO 2011/018356 ein Verfahren beschrieben, wobei eine Haftklebemasse als Barriereschicht um eine elektronische Anordnung aufgebracht wird. Der Barrierekleber wirkt als Kapsel um ein Eindringen von Permeanten zu verhindern und die Lebensdauer der OLEDs zu verlängern.

Auch in der WO 2014/048971 wird eine Verkapselung eines optoelektronischen Bauelementes aus einem anorganischen Stoffgemisch offenbart, welches auch als Haftschicht aufgebracht wird. Durch die Verkapslung soll eine hermetische Abdichtung der elektrisch aktiven Bereiche einer OLED oder einer Solarzelle, insbesondere gegenüber Wasserdämpfen oder Sauerstoff, erreicht werden.

Im bekannten Stand der Technik werden die optoelektronischen Bauteile zunächst unter einer Schutzatmosphäre (zumeist aus Stickstoff) hergestellt. Hierbei kommen lösungsmittelbasierte Prozesse und thermisches Aufdampfen im Vakuum zur Anwendung. Nach der Fertigung des eigentlichen organischen oder hybriden optoelektronischen Bauelementes wird dieses nochmal mit einer speziellen Folie oder Glas verkapselt, um es insbesondere vor dem Einwirken von Sauerstoff und Wasser zu schützen. Üblicherweise kann zudem noch zwischen das Bauelement und die Barrierekapsel (z.B. aus Glas oder einem speziellen Kunststofffilm) eine dünne Schicht eines absorbierenden Materials, ein sogenannter Getterstoff platziert werden. Dieser dient dazu, bereits vorhandenes Wasser oder Sauerstoff zu binden. Als Barriereschicht zur Verkapselung zeichnet sich Glas durch eine geringe Permeation gegenüber Wasser aus. Glas ist jedoch nicht biegsam. Für Anwendungen bei denen eine flexible, dünne Elektronik notwendig ist, z.B. im Falle Displays, Sensoren, Transistoren, Solarzellen etc., erfolgt die Verkapselung daher zumeist mit einem Plastikfilm, welcher spezielle Beschichtungen aufweist, die die Barriereschicht bilden. Der Plastikfilm, wie z.B. PET, PEN und ähnliche, bietet meist selbst keine ausreichende Barrierewirkung. Die Barriereeigenschaft dieser Folien basiert daher auf den speziellen Beschichtungen und auf folgendem Phänomen: Die Wasser- bzw. Sauerstoffmoleküle können normalerweise eine anorganische Blockschicht nicht durchdringen. Es wird aber nie eine perfekte dünne anorganische Blockschicht hergestellt, sondern zumeist treten nanometerfeine kleine Defekte auf, durch die vereinzelten Moleküle hindurchdiffundieren bzw. hindurchwandern. Eine zweite Schicht, welche diffusionslimitierend ist und zwischen den einzelnen anorganischen Blockschichten platziert wird, dient dazu, die (Diffusions-)Weglänge der einzelnen Wasser oder Sauerstoffmoleküle zu erhöhen, bis diese wieder einen Defekt in der zweiten Blockschicht erreichen. Die Barrierefolien umfassen daher zumeist einen Aufbau mit wechselnden Blockschichten oder Diffusionsbarrieren und diffusionslimitierenden Schichten, welche insgesamt zu akzeptablen Blockeigenschaft führen und somit eine Permeation von Wasserdampf oder Sauerstoff verhindern. Im Stand der Technik wird die Permeation üblicherweise durch eine Dampftransmissionsrate (engl. *vapour transmission rate,* VTR) oder speziell für Wasser, eine Wasserdampftransmissionsrate (engl. water *vapour transmission rate,* WVTR) angeben. Übliche WVTR- und VTR-Werte für Barrierefolien oder Barrieresubstrate aus dem Stand der Technik betragen zwischen 1 bis 10⁻⁶ Gramm Wasser / (24 Stunden * cm² Barrierefläche) oder cm³ Dampf / (24 Stunden * cm² Barrierefläche). Die Dicke handelsüblicher Barrierefolien oder Barrieresubstrate zur Verkapselung beträgt zwischen 25 bis 100 Mikrometer (µm). Für flexible Anwendungen wird die Barrierefolie oftmals selbstklebend von beiden Seiten auf das optoelektronische Bauelement aufgebracht. Die einzelnen Schichten der Barrierefolie sowie die gesamte Barrierefolie selbst erfüllen im Stand der Technik keine elektrische Eigenschaft zur Leitung der Ladungsträger, sondern dienen nur zum Schutz des Bauelementes vor Degradationsprozessen aufgrund von Wasser oder Sauerstoff

Nachteilig an den bekannten Verfahren und der Verwendung von Barrierefolien ist insbesondere die hohe Schichtdicke. Aufgrund eines benötigten Trägersubstrats, d.h. zumeist einer Plastikfolie, sowie den funktionellen Barriereschichten, d.h. den beschriebenen anorganischen Blockschichten (Diffusionsbarrieren) sowie diffusionslimitierende Schichten ist die Gesamtdicke einer Barrierefolie zumeist mindestens 50 µm. Das zu verkapselnde optoelektronische Bauelement selbst ist zumeist nur ca. 50 µm dick. Bei einer beidseitigen Verkapselung führt die Verkapselung somit zu einer Verdreifachung der Dicke des Bauelementes auf eine gesamte Mindestdicke von 150 µm gegenüber den möglichen 50µm. Dies führt dazu, dass das zu verkapselnde Bauteil an Steifigkeit zunimmt und seine Flexibilität abnimmt. Hierdurch werden die Einsatzmöglichkeiten beispielsweise in Bezug auf elektronisches Papier deutlich einschränkt. Zudem können bei der Verkapslung der Bauelemente mit Barrierefolien Probleme an den Rändern des zu verklebenden Bauelementes auftreten. An diesen Stellen kommt es aufgrund der Biegung zu einer erhöhten mechanischen Belastung und die Barrierefolie kann sich trotz Haftschicht und Kleber lösen, was zu einem verminderten Schutz und einer herabgesetzten Lebensdauer führt. Zudem treten während der Verkapselung, d.h. insbesondere während des Aufklebens der Barrierefolien, oftmals Gaseinschlüsse zwischen der Barrierefolie und dem Bauteil auf. Dies erhöht die Ausfallrate der produzierten optoelektronischen Bauelemente und somit die Kosten. Aufgrund der relativ hohen Kosten der Barrierefolien sowie der Notwendigkeit eines zusätzlichen Prozessschrittes, welcher die Wahrscheinlichkeit des Auftretens eines Defektes erhöht, werden die Produktionskosten weiter gesteigert. Ebenfalls können die optischen Eigenschaften aufgrund einer verringerten Transmission und einer höheren Streuung der Barrierefolien eingeschränkt sein.

Es sind aus dem Stand der Technik auch schichtartig konzipierte OLEDs bekannt, deren einzelne funktionale Elemente, beispielsweise deren Elektroden, barriereartige Eigenschaften aufweisen.

Aus der US 2015/0228925 A1 sind OLEDs bekannt, welche Landungstransport- als auch Ladungsinjektionsschichten aufweisen, welche Barriereeigenschaften gegenüber Wasser und Sauerstoff aufweisen.

Kwanghee Lee et al.,"Air-Stable Polymer Electronic Devices", Advanced Materials, 19, S.2445 - 2449, 2007 offenbart eine PLED (polymer light-emitting diode), bei der zwischen der optisch aktiven Schicht und der Aluminium-Kathode eine elektronentransportierende TiOₓ- (Titanoxid-) Schicht platziert wird. Mittels der Schicht soll die Stabilität der PLED gegenüber Sauerstoff und Wasser verbessert werden.

Eunjung Kang et al., "Organic electroluminescent devices using poly(vinylidene fluoride-co-hexafluoropropylene) doped with triphenylamine derivative as a holetransporting layer", Proceedings optical diagnostics of living cells II, Bd. 3281, S. 336-344, 1998 offenbart organisch elektrolumineszente Vorrichtungen, die als Lochtransportschicht PVdF-HFP (Polyvinylidenfluorid-Co-Hexafluorpropylen) mit TPD (N,N'-Diphenyl-N,N'-Din-tolylbenzidin) verwenden, um eine gute Leitfähigkeit L und eine ausreichende thermische Stabilität zu erzielen.

Dong-hyun Lee et al., "Polymer Organic Light-Emitting Devices with Cathodes Transferred under Ambient Conditions", Japanese Journal of Applied Physics, S. 50, 110206, 2011, offenbart eine OLED sowie ein vakuumfreies Verfahren zur Herstellung derselben, wobei Cs₂CO₃-dotiertes PVA (Polyvinylalkohol) bei der Herstellung von Polymer-OLEDs unter Umgebungsbedingungen als mit Al versetzte Kathode verwendet werden kann.

Hyo-min Kim et al., "Semi-transparent quantum-dot light emitting diodes with an inverted structure", Journal of Materials Chemistry C: Materials for Optical and Electronic Devices, Bd. 2, Nr. 12, 2014 offenbart eine QLED (quantum-dot light emitting diode), die im roten Emissionsbereich halb-transparent ist. Die QLED umfasst eine AZO:Cs₂CO₃-Schicht auf der Kathodenseite, welche eine schützende Funktion ausführen soll.

Jingbi You et al., "Improved air stability of perovskite solar cells via solution-processed metal oxide transport layers", Nature Nanotechnology, Bd. 11, Nr. 1, S.75-81, 2015 offenbart eien Solarzelle mit einer verbesserten Luftstabilität, wobei NiOₓ und ZnO als Transportschichten verwendet wurden.

Anand S. Subbiah et al., "Inorganic Hole Conducting Layers for Perovskite-based Solar Cells", Journal of Physical Chemistry Letters, Bd. 5, Nr. 10, S.1748-1753 untersucht den Einsatz anorganischer Transportschichten für Perowskit-Solarzellen und schlussfolgert, dass NiOₓ und CuSCN organische Transportschichten ersetzen könnten.

Dong-Hee Park et al., "Flexible Audible Display using ITO on PVDF and its Interface Analysis", MRS Proceedings, Bd. 1116, 2008, beschreibt ein flexibles akustisches Bauelement, welches eine Schichtenfolge aus LiF-Elektroneninjektionsschicht, Alq3-Elektronentransportschicht, NPB- (Ninhydrin-Petroleumbenzin-) Lochtransportschicht und eine NATA- (Natriumchloracetat-) Lochinjektionsschicht umfasst.

### AUFGABE DER ERFINDUNG

Aufgabe der Erfindung war es somit ein optoelektronisches Bauelement bereitzustellen, welches die Nachteile des Standes der Technik beseitigt. Insbesondere sollte ein optoelektronisches Bauelement bereitgestellt werden, welches sich gegenüber dem Stand der Technik durch eine kosteneffektive Herstellung, hohe Lebensdauer und hohe Flexibilität aufgrund einer geringen Dicke auszeichnet.

### ZUSAMMENFASSUNG DER ERFINDUNG

Die erfindungsgemäße Aufgabe wird durch ein optoelektronisches Bauelement sowie ein Verfahren zur Herstellung desselben gemäß den unabhängigen Patentansprüchen gelöst. Die abhängigen Patentansprüche stellen bevorzugte Ausführungsformen der Erfindung dar.

Die Erfindung betrifft ein optoelektronisches Bauelement mit einer Kathode und einer Anode und einem Schichtsystem zwischen der Kathode und der Anode umfassend mindestens eine kathodennahe Elektroneninjektionsschicht oder -extraktionsschicht, mindestens eine Elektronentransportschicht, mindestens eine optisch aktive Schicht, mindestens eine Lochtransportschicht, mindestens eine anodennahe Lochinjektionsschicht oder -extraktionsschicht. Die mindestens eine Elektroneninjektionsschicht oder -extraktionsschicht und die mindestens eine Lochinjektionsschicht oder -extraktionsschicht sind diffusionslimitierend gegenüber Wasser und Sauerstoff und weisen eine Wasserdampftransmissionsrate (WVTR) von weniger als 1 g/(m²*d) und eine Sauerstofftransmissionsrate (OTR) von weniger als 1 cm³/(m²*d) auf. Die mindestens eine Elektronentransportschicht und die mindestens eine Lochtransportschicht stellen eine Diffusionsbarriere gegenüber Wasser und Sauerstoff dar und weisen eine Wasserdampftransmissionsrate (WVTR) von weniger als 0,1 g/(m²*d) und eine Sauerstofftransmissionsrate (OTR) von weniger als 0,1 cm³/(m²*d) auf. Die mindestens eine Elektronentransportschicht umfasst ein dotiertes Metalloxid, die mindestens eine Lochtransportschicht umfasst ein dotiertes Metallthiocyanat und/oder ein dotiertes Metalloxid, die mindestenes eine Elektroneninjektionsschicht oder -extraktionsschicht umfasst dielektrische Polymere und die mindestens eine Lochinjektionsschicht oder -extractionsschicht umfasst dielektrische Polymere.

Das erfindungsgemäße optoelektronische Bauelement ist dadurch gekennzeichnet, dass dieses Elektroden (d.h. eine Anode oder Kathode), eine optisch aktive Schicht sowie elektrisch aktive Schichten (d.h. insbesondere die Ladungsträgerinjektions- oder extraktionsschichten sowie Ladungsträgertransportschichten) umfasst. Die Funktionalität des optoelektronischen Bauelementes wird bevorzugt durch die optisch aktive Schicht gekennzeichnet, welche insbesondere der Licht- oder Stromerzeugung dienen. Die elektrisch aktiven Schichten bezeichnen im Sinne der Erfindung bevorzugt jene Schichten, welche die elektrische Funktionalität des Bauelementes gewährleisten und zwischen der optisch aktiven Schicht und den Elektroden angeordnet sind. Im Sinne der Erfindung sind die Ladungsträgerinjektions- oder extraktionsschichten sowie Ladungsträgertransportschichten elektrisch aktive Schichten. Weiterhin werden im Sinne der Erfindung unter Ladungsträger bevorzugt Elektronen oder Elektronenlöcher verstanden. Der Begriff Loch oder Elektronenloch wird vorliegend bevorzugt synonym verwandt. Der Fachmann weiß, wie die elektrisch aktiven Schichten anzuordnen sind, um in Abhängigkeit der optisch aktiven Schicht die gewünschte Funktion des optoelektronischen Bauelementes zu erzielen.

Im Wesentlichen betrifft die Erfindung bevorzugt zwei Gruppen von optoelektronischen Bauelementen. Bei der ersten Gruppe ist die optisch aktive Schicht bevorzugt eine Emitterschicht, welche der Lichterzeugung dient. In dem Falle wird das optoelektronische Bauelement bevorzugt als organische oder hybride Leuchtdiode (LED) eingesetzt. Bei der zweiten Gruppe ist die optisch aktive Schicht bevorzugt eine Absorberschicht, in der freie Ladungsträger durch die Absorption elektromagnetischer Strahlung erzeugt werden. Bei der zweiten Gruppe der optoelektronischen Bauelemente handelt es sich somit bevorzugt um organische oder hybride Solarzellen oder Fotodetektoren.

Wie obig beschrieben, erfolgt eine Auswahl der elektrischen Schichten, um die Funktion der optisch aktiven Schicht des Bauelementes zu gewährleisten.

In einer bevorzugten Ausführungsform betrifft die Erfindung ein optoelektronisches Bauelement zur Erzeugung von Licht beispielsweise als Leuchtdiode. In dieser bevorzugten Ausführungsform umfasst das optoelektronische Bauelement eine Kathode und eine Anode und ein Schichtsystem zwischen der Kathode und der Anode umfassend mindestens eine kathodennahe Elektroneninjektionsschicht, mindestens eine Elektronentransportschicht, mindestens eine optisch aktive Schicht, welche eine Emitterschicht ist, mindestens eine Lochtransportschicht, mindestens eine anodennahe Lochinjektionsschicht und ist dadurch gekennzeichnet, dass die mindestens eine Elektroneninjektionsschicht und die mindestens eine Lochinjektionsschicht diffusionslimitierend gegenüber Wasser und/oder Sauerstoff sind und die mindestens eine Elektronentransportschicht und die mindestens eine Lochtransportschicht eine Diffusionsbarriere gegenüber Wasser und/oder Sauerstoff darstellen.

Die Kathode dient in dieser bevorzugten Ausführungsform als Elektronenlieferant. Bevorzugt weist die Kathode einen geringen Flächenwiderstand auf, um eine möglichst gleichmäßige Injektion der Elektronen über die Fläche der OLED zu ermöglichen.

Die Elektroneninjektionsschicht hingegen erfüllt die Funktion die Austrittsarbeit der Kathode und der folgenden Schicht, der Elektronentransportschicht, anzugleichen. Die Austrittsarbeit (engl. *work function*) entspricht bevorzugt der Energie, die mindestens aufgewandt werden muss, um ein Elektron aus einem ungeladenen Festkörper herauszulösen. Durch das Angleichen der Austrittsarbeit der Kathode zu der Elektronentransportschicht wird die Spannung herabgesetzt, die notwendig ist, um Elektronen von der Kathode in die Elektronentransportschicht einzuspeisen bzw. zu injizieren.

Die Elektronentransportschicht dient dem gerichteten Elektronentransport zwischen Kathode und der optisch aktiven Schicht, d.h. der bevorzugten Ausführungsform der Emitterschicht. Dazu sollte die Elektronentransportschicht bevorzugt eine genügende Beweglichkeit oder Mobilität von Elektronen (bevorzugt von 10⁻⁶ bis 100 cm²/ (V * sec)) aufweisen. Zusätzlich sollte bevorzugt das Ladungstransportenergielevel, d.h. das Leitungsband bzw. LUMO (engl. *lowest unnoccupied molecular orbital*) der Elektronentransportschicht, zwischen dem Energielevel des Emittermaterials und der Austrittsarbeit der Kathode liegen, d.h., dass nach Leisten der Austrittsarbeit keine zusätzliche Energie zum Transport der Elektronen vor der Rekombination mit den Löchern nötig ist.

Die Emitterschicht besteht bevorzugt aus halbleitenden organischen Polymeren oder Molekülen, die bei elektrischer Anregung Licht im sichtbaren Bereich produzieren, d.h. bevorzugt in einem Wellenlängenbereich von 400 bis 700 nm. In der Emitterschicht rekombinieren bevorzugt die Elektronen der Kathode mit den Löchern der Anode zu Exzitonen. Bevorzugt überwiegt dabei der Anteil an Singlet-Exzitonen, sodass es zu einer effektiven Lichterzeugung kommt.

Die Lochtransportschicht ist das Pendant zur Elektronentransportschicht und dient dem Transport von (Elektronen-)Löchern aus der Anode zur Emitterschicht. Bevorzugt sollte die Lochtransportschicht daher eine genügende Beweglichkeit oder Mobilität von Elektronenlöchern, bevorzugt von 10⁻⁶ bis 100 cm²/ (V * sec), aufweisen. Zusätzlich sollte bevorzugt das Energielevel für den Transport der Elektronenlöcher, d.h. das Leitungsband bzw. HOMO (engl. *highest occupied molecular orbital*) der Lochtransportschicht zwischen dem Energielevel des Emittermaterials und der Austrittsarbeit der Anode liegen.

Die Lochinjektionsschicht besteht wie ihr Pendant auf der Kathodenseite (die Elektroneninjektionsschicht) vorzugsweise aus stark dielektrischen Polymeren und ist bevorzugt ein Isolator. Bevorzugt dient die Lochinjektionsschicht dazu, die Energieniveaus der Anode und der folgenden Schicht, der Lochtransportschicht anzugleichen, um eine effektive Injektion von Elektronenlöchern zu gewährleisten.

Die Anode ist bevorzugt der Elektronenlochlieferant und weist daher bevorzugt eine deutlich höhere Austrittsarbeit als die Kathode auf. Weiterhin ist es bevorzugt, dass die Anode eine hohe Flächenleitfähigkeit für Löcher aufweist. Zudem kann es bevorzugt sein, dass das Anodenmaterial transparent ist, um vorzugsweise durch die Anode den Lichtaustritt zu ermöglichen.

In dieser bevorzugten Ausführungsform ist die optisch aktive Schicht eine Emitterschicht und die elektrisch aktiven Schichten mindestens eine Elektroneninjektionsschicht, mindestens eine Elektronentransportschicht, mindestens eine Lochtransportschicht und mindestens eine Lochinjektionsschicht.

Für die bevorzugte Ausführungsform, in welcher es statt zu einer Lichterzeugung zu einer Stromerzeugung durch das Bauelement kommen soll, weiß ein Fachmann die elektrisch aktiven Schichten und optisch aktiven Schichten bevorzugt wie folgt anzupassen.

Als optisch aktive Schicht wird bevorzugt eine Absorberschicht verwandt, welche in der Lage ist, durch Photonenabsorption die Energie der einfallenden elektromagnetischen Strahlung in die Erzeugung freier Ladungsträger umzuwandeln. Die elektrisch aktiven Schichten sorgen bevorzugt dafür, dass innerhalb des optoelektronischen Bauelementes ein internes elektrisches Feld generiert wird, welches die Ladungsträger zu den entsprechenden Elektroden abzieht. An der Kathode werden die Elektronen extrahiert, während an der Anode die Löcher extrahiert werden. Der dadurch bereitgestellte Potentialunterschied dient der Erzeugung von elektrischer Spannung bzw. unter Last elektrischem Strom.

In dieser bevorzugten Ausführungsform des optoelektronischen Bauelementes liegt der Schichtaufbau bevorzugt wie folgt vor.

Das optoelektronisches Bauelement umfasst eine Kathode und eine Anode und ein Schichtsystem zwischen der Kathode und der Anode umfassend mindestens eine kathodennahe Elektronenextraktionsschicht, mindestens eine Elektronentransportschicht, mindestens eine optisch aktive Schicht, welche eine Absorberschicht ist, mindestens eine Lochtransportschicht, mindestens eine anodennahe Lochextraktionsschicht und ist dadurch gekennzeichnet, dass die mindestens eine Elektronenextraktionsschicht und die mindestens eine Lochextraktionsschicht diffusionslimitierend gegenüber Wasser und Sauerstoff sind und die mindestens eine Elektronentransportschicht und die mindestens eine Lochtransportschicht eine Diffusionsbarriere gegenüber Wasser und Sauerstoff darstellen.

Die elektrisch aktiven Schichten sind wiederum derart konzipiert, um die Funktion der Absorberschicht und eine effektive Extraktion der Ladungsträger zu gewährleisten. In dieser bevorzugten Ausführungsform ist die optisch aktive Schicht eine Absorberschicht und die elektrisch aktiven Schichten die mindestens eine Elektronenextraktionsschicht, die mindestens eine Elektronentransportschicht, die mindestens eine Lochextraktionsschicht und die mindestens eine Lochtransportschicht. Erfindungsgemäß wurde erkannt, dass zur Verlängerung der Lebensdauer der optoelektronischen Bauelemente insbesondere ein Schutz der optisch aktiven Schicht vor dem schädlichen Einfluss von Wasser bzw. Wasserdämpfen sowie Sauerstoff erfolgen sollte. Während es im Stand der Technik zumeist zu einer Verkapselung des gesamten Bauelementes kommt, werden erfindungsgemäß die elektrisch aktiven Schichten genutzt, um eine Blockadefunktion gegenüber Wasser und Sauerstoff zu erfüllen.

Bei den lichterzeugenden Bauelementen sind die mindestens eine Elektroneninjektionsschicht und die mindestens eine Lochinjektionsschicht diffusionslimitierend gegenüber Wasser und Sauerstoff Die mindestens eine Elektronentransportschicht und die mindestens eine Lochtransportschicht bilden eine Diffusionsbarriere gegenüber Wasser und Sauerstoff bilden. Im Falle der stromerzeugenden Bauelemente sind hingegen die Elektronen- und Lochextraktionsschichten diffusionslimitierend gegenüber Wasser und Sauerstoff. Die mindestens eine Elektronentransportschicht und die mindestens eine Lochtransportschicht bilden weiterhin eine Diffusionsbarriere gegenüber Wasser und Sauerstoff.

Durch diese duale Funktionalität der elektrisch aktiven Schichten sowohl als Permeationsbarrieren für Wasser und Sauerstoff, als auch zur Unterstützung des gerichteten Stromes der Ladungsträger, können die Bauelemente deutlich kompakter konstruiert werden. Während es im Stand der Technik notwendig, ist Barrierefolien einzusetzen, wodurch die Gesamtdicke des Bauelementes oftmals um das Dreifache erhöht wird, entfällt dies vorteilhafterweise bei dem erfindungsgemäßen Schichtaufbau. Hierdurch sind die optoelektronischen Bauelemente deutlich biegsamer und lassen sich flexibler einsetzen. Auch entfallen zusätzliche Produktionsschritte zur Applikation der Barrierefolien, wodurch der Herstellungsprozess deutlich vereinfacht und verbilligt wird. Durch die Verwendung der elektrisch aktiven Schichten als diffusionslimitierende Schichten bzw. Diffusionsbarrieren können die Bauelemente zuverlässiger und kostengünstiger produziert werden, als es im Stand der Technik möglich ist. Der technische Fortschritt, der durch die Erfindung erzielt wird, zeigt sich des Weiteren in einem leistungsstärkeren Bauelement, welches bei gleicher elektrischer Leistungsaufnahme eine höhere Intensität und bessere optische Eigenschaften (geringere Streuung, monochromatisches Licht) bzw. Erzeugung größerer elektrischer Leistung bei gleicher Intensität der Sonneneinstrahlung aufweist. Hier hat sich die innovative Forschung und das methodische Vorgehen der Erfinder bezahlt gemacht, durch die Nutzung der elektroaktiven Schichten als Barriere gegen Sauerstoff und Wasser wurde ein neuer Weg beschritten.

Dabei war es überraschend, dass elektrisch aktive Schichten bereitgestellt werden können, welche sowohl die Blockadefunktion als auch die elektrische Funktion zur Führung der Ladungsströme erlauben. Dadurch, dass jede einzelne Schicht, welche eine elektrischen Funktion aufweist, auch eine Blockadefunktion gegenüber Sauerstoff und Wasser übernimmt, kann eine überraschend effektive Barriere gegenüber diesen erzielt werden. Die Barrierefunktionalität jeder einzelnen Schicht erhöht so die Lebensdauer des optoelektronischen Bauelementes erheblich. Der Effekt, der durch das Zusammenwirken verschiedener Barriereschichten erzielt werden kann, ist erheblich größer als der einer einzelnen Barriereschicht. Umso mehr Schichten mit Barriereeigenschaften übereinander angeordnet sind, umso stärker wirkt deren nichtlineares Zusammenwirken, bei dem bevorzugt die Kombination mehrerer Barriereschichten eine höhere Barrierewirkung aufweist, als sich durch die Summe der Barrierewirkungen der einzelnen Schichten ergeben würde. Hier zeigt sich ein synergistischer Effekt. Mit Barriere- oder Blockadeeigenschaften sind in diesem Zusammenhang sowohl Diffusionslimitierende-, als auch Diffusionsblockadeeigenschaften gemeint.

Im Gegensatz zu der Anwendung von Barrierefolien kommt es außerdem nicht zu Problemen an den Rändern des Bauelements. Durch den mikroskopischen Aufbau der elektroaktiven Schichten im Gegensatz zum makroskopischen Aufbau einer Barrierefolie können makroskopische Gaseinschlüsse, wie sie bei Barrierefolien auftreten, effektiv verhindert werden.

Es war überraschend, dass die Barriereeigenschaften und die gewünschten elektrischen Eigenschaften der elektroaktiven Schichten insbesondere durch die Auswahl geeigneter Materialien und Schichtdicken, wie weiter unten beschrieben, zu erzielen war.

Im Sinne der Erfindung wird unter der Eigenschaft "diffusionslimitierend gegenüber Wasser und/oder Sauerstoff" bevorzugt verstanden, dass die entsprechenden Injektions- bzw. Extraktionsschichten die Diffusion von Wasser und/oder Sauerstoffmolekülen deutlich reduzieren. So kann es bevorzugt sein, dass durch die diffusionslimitierenden Schichten die Weglänge der Wasser und Sauerstoffmoleküle in der Schicht erhöht wird, sodass die Moleküle nicht zu den optisch aktiven Schichten gelangen.

Erfindungsgemäß weisen die Elektroneninjektionsschicht (29) oder - extraktionsschicht und die mindestens eine Lochinjektionsschicht (31) oder-extraktionsschicht eine Wasserdampftransmissionsrate (WVTR) von weniger als 1 g/(m²*d) und eine Sauerstofftransmissionsrate (OTR) von weniger als 1 cm³/(m²*d) auf.

Im Sinne der Erfindung wird unter der Eigenschaft "Diffusionsbarriere" bevorzugt verstanden, dass die entsprechenden Elektronen- bzw. Lochtransportschichten die Permeation von Wasser- und Sauerstoffmolekülen verhindern bzw. sehr deutlich reduzieren. Erfindungsgemäß weisen die Elektronen- bzw. Lochtransportschichten als Diffusionsbarrieren eine Wasserdampftransmissionsrate (WVTR) von weniger als 0,1 g/(m²*d) und eine Sauerstofftransmissionsrate (OTR) von weniger als 0,1 cm³/(m²*d) auf.

Es ist jedoch besonders bevorzugt, dass die Blockadeeigenschaften der elektrisch aktiven Schichten zusammen mit den Elektroden Bedingungen genügen, welche einen effektiven Schutz der optisch aktiven Schicht vor Permeation von Wasser und Sauerstoff gewährleisten.

In der bevorzugten Ausführungsform ist das optoelektronisches Bauelement dadurch gekennzeichnet, dass eine Schichtkombination aus einer Kathode, der mindestens einen Elektroneninjektionsschicht oder -extraktionsschicht und der mindestens einen Elektronentransportschicht zusätzlich eine Wasserdampftransmissionsrate (WVTR) von weniger als 0,01 g/(m²*d) und eine Sauerstofftransmissionsrate (OTR) von weniger als 0,01 cm³/(m²*d) aufweist und/oder eine Schichtkombination aus einer Anode, der mindestens einen Lochinjektionsschicht oder -extraktionsschicht und der mindestens einen Elektronentransportschicht eine Wasserdampftransmissionsrate (WVTR) von weniger als 0,01 g/(m²*d) und eine Sauerstofftransmissionsrate (OTR) von weniger als 0,01 cm³/(m²*d) aufweist. Die Schichten können gemäß ihrer Zusammensetzung und Dicke vom Fachmann routinemäßig so angepasst werden, dass die genannten Transmissionsraten erzielt werden können.

Es wurde erkannt, dass bevorzugt nicht die einzelnen diffusionslimitierenden Schichten bzw. Diffusionsbarrieren quantitativen Blockadeeigenschaften genügen müssen, sondern insbesondere die Schichtkombination bevorzugt aus der Elektrode und den elektrisch aktiven Schichten bis zur optisch aktiven Schicht. Hierbei kann es bevorzugt sein, dass bereits die Kombination aus einer Elektrode sowie einer Injektions- bzw. Extraktionsschicht und einer Transportschicht bevorzugt eine WVTR bzw. OTR von weniger als 0,01 g/(m²*d) bzw. weniger als 0,01 cm³/(m²*d) aufweist. Es kann aber auch bevorzugt sein, dass das Bauelement mehrere bevorzugt alternierende Injektions- bzw. Extraktionsschichten und Transportschichten umfasst, wobei die Schichtkombination beispielsweise der Kathode mit den gesamten Elektroneninjektionsschichten und Elektronentransportschichten eine WVTR bzw. OTR von weniger als 0,01 g/(m²*d) bzw. weniger als 0,01 cm³/(m²*d) aufweist. Gleiches gilt entsprechend für die anderen elektrisch aktiven Schichten. D.h. es kann auch bevorzugt sein, dass die Schichtkombination der Anode mit den gesamten Lochinjektionsschichten und Lochtransportschichten eine WVTR bzw. OTR von weniger als 0,01 g/(m²*d) bzw. weniger als 0,01 cm³/(m²*d) aufweist. Für die Ausführungsform der stromerzeugenden Bauelemente, wie Solarzellen oder Fotodetektoren, sind in den Schichtkombinationen die Injektionsschichten durch Extraktionsschichten zu ersetzen.

Überraschenderweise führen die genannten Werte der WVTR bzw. OTR für die Schichtkombinationen von weniger als 0,01 g/(m²*d) bzw. weniger als 0,01 cm³/(m²*d) zu einem besonders effektiven Schutz der optisch aktiven Schichten. So erhöhen sich für die bevorzugte Ausführungsform die Lebensdauern der bevorzugten Solarzellen bzw. Leuchtdioden erheblich.

Diese Ausführungsform mit den vorgenannten Werten stellt aufgrund der starken, synergistischen Barriereeigenschaften, die sich durch die Kombination der einzelnen Schichten ergeben, ein besonders wartungsfreies Bauelement dar.

Die lichtemittierende Bauart des Bauelements spielt zur Verwendung in Printerzeugnissen eine große Rolle. Die hier vorgestellte Ausführungsform hat sich als besonders wenig fehleranfällig bei Papierdruck erwiesen.

Es kann ebenfalls bevorzugt sein, das in einer bevorzugten Ausführungsform das optoelektronisches Bauelement dadurch gekennzeichnet ist, dass eine Schichtkombination aus einer Kathode, der mindestens einen Elektroneninjektionsschicht oder -extraktionsschicht und der mindestens einen Elektronentransportschicht eine Wasserdampftransmissionsrate (WVTR) von weniger als 0,1 g/(m²*d) und eine Sauerstofftransmissionsrate (OTR) von weniger als 0,1 cm³/(m²*d) aufweist und/oder eine Schichtkombination aus einer Anode, der mindestens einen Lochinjektionsschicht oder -extraktionsschicht und der mindestens einen Elektronentransportschicht eine Wasserdampftransmissionsrate (WVTR) von weniger als 0,1 g/(m²*d) und eine Sauerstofftransmissionsrate (OTR) von weniger als 0,1 cm³/(m²*d) aufweist. Hierbei kann es bevorzugt sein, dass bereits die Kombination aus einer Elektrode sowie einer Injektions- bzw. Extraktionsschicht und einer Transportschicht bevorzugt eine WVTR bzw. OTR von weniger als 0,1 g/(m²*d) bzw. weniger als 0,1 cm³/(m²*d) aufweist. Es kann aber auch bevorzugt sein, dass das Bauelement mehrere bevorzugt alternierende Injektions- bzw. Extraktionsschichten und Transportschichten umfasst, wobei die Schichtkombination beispielsweise der Kathode mit den gesamten Elektroneninjektionsschichten und Elektronentransportschichten eine WVTR bzw. OTR von weniger als 0,1 g/(m²*d) bzw. weniger als 0,1 cm³/(m²*d) aufweist. Gleiches gilt entsprechend für die anderen elektrisch aktiven Schichten. D.h. es kann auch bevorzugt sein, dass die Schichtkombination der Anode mit den gesamten Lochinjektionsschichten und Lochtransportschichten eine WVTR bzw. OTR von weniger als 0,1 g/(m²*d) bzw. weniger als 0,1 cm³/(m²*d) aufweist. Für die Ausführungsform der stromerzeugenden Bauelemente, wie Solarzellen oder Fotodetektoren, sind in den Schichtkombinationen die Injektionsschichten durch Extraktionsschichten zu ersetzen.

Durch die Erkenntnis, dass es für bestimmte Ausführungsformen ausreichend sein kann, genannte Werte für die Schichtkombinationen zu realisieren, können besonders dünne Schichten verwendet werden, um die gewünschten Funktionalitäten zu erzielen.

Überraschenderweise führen die genannten Werte der WVTR bzw. OTR für die Schichtkombinationen von weniger als 0,1 g/(m²*d) bzw. weniger als 0,1 cm³/(m²*d) zu einem Bauelement mit besonders zuverlässig im Voraus bestimmbaren elektrischen Eigenschaften, welches gleichzeitig ausreichend vor Sauerstoff und Wasser geschützt ist. Es können des Weiteren bei gleichzeitig guten Schutzeigenschaften und somit langer Lebensdauer des Bauelements besonders dünne Schichten verwendet werden. Somit wird ein überraschend langlebiges und flexibles Bauelement realisiert.

Ebenso können auf diese Weise lichtemittierenden Bauelemente mit besonders vorteilhaften ästhetischen Eigenschaften (optische Brillanz) realisiert werden. So können lichtemittierenden Bauelemente mit den vorstehend genannten Eigenschaften beispielsweise auch für ganz dünnes Papier, wie beispielsweise das von Tageszeitungen, verwendet werden, um einen optischen Effekt (bspw. blinkende Lampen für Autowerbung) zu erzielen.

Im Sinne der Erfindung ist es bevorzugt, dass die Wasserdampftransmissionsrate (WVTR) ein Messwert für die Durchlässigkeit von Wasserdampf bzw. Wassermolekülen durch die einzelne Schicht bzw. durch Schichtkombination darstellt. Zur Ermittlung des WVTR-Wertes wird bevorzugt die Masse der Wassermoleküle, welche innerhalb von 24 Stunden durch eine Fläche der Schicht diffundieren, bestimmt. Vorliegend wird als bevorzugte Einheit die WVTR in g/(m²*d) angegeben. Wobei die SI-Einheiten g für Gramm, d für Tag, d.h. 24 Stunden, und m² für Quadratmeter der Fläche der Schicht bzw. Kombinationsschicht steht.

Analog ist es im Sinne der Erfindung bevorzugt, dass die Sauerstofftransmissionsrate (OTR) ein Messwert für die Durchlässigkeit von Sauerstoffmolekülen durch die einzelne Schicht bzw. durch Schichtkombination darstellt. Zur Ermittlung des OTR-Wertes wird bevorzugt das Gasvolumen der Sauerstoffmoleküle, welche innerhalb von 24 Stunden durch eine Fläche der Schicht diffundieren bestimmt. Vorliegend wird als bevorzugte Einheit die OTR in cm³/(m²*d) angegeben. Wobei die SI-Einheiten cm³ für Kubikzentimeter, also dem Volumen der diffundierten Sauerstoffmoleküle steht, d für Tag, d.h. 24 Stunden, und m² für Quadratmeter, d.h. der Fläche der Schicht bzw. Kombinationsschicht, stehen.

Der Fachmann weiß, wie die OTR und WVTR von Dünnschichten experimentell bestimmbar sind und kann daher die Schichten entsprechend dieser Eigenschaften auswählen.

Experimentelle Tests zur Bestimmung der OTR und WVTR von dünnen Schichten von optoelektronischen Bauelementen werden beispielsweise von der American Society for Testing and Materials (ASTM) unter der ASTM D1653-13 mit dem Titel Standard Test Methods for Water Vapor Transmission of Organic Coating Films offenbart. Das Dokument für die Beschreibung der Tests ließ sich am 12.09.2016 unter https://www.astm.org/Standards/D1653.htm runterladen.

Erfindungsgemäß ist das optoelektronische Bauelement dadurch gekennzeichnet, dass die mindestens eine Elektronentransportschicht und die mindestens eine Lochtransportschicht eine Sauerstofftransmissionsrate (OTR) von weniger als 0,1 cm³/(m²*d) und eine Wasserdampftransmissionsrate (WVTR) von weniger als 0,1 g/(m²*d) aufweisen. Vorteilhafterweise führen diese Parameterwerte für die einzelnen Transportschichten zu einer effektiven Vermeidung der Permeation von Wasser- oder Sauerstoffmolekülen. Es wurde von den Erfindern erkannt, dass der Elektronentransportschicht und der Lochtransportschicht diesbezüglich eine besondere Bedeutung zukommt, da sie die optisch aktive Schicht direkt umgeben. Mit den vorgenannten Werten kann ein besonders zuverlässiges und langlebiges Bauteil zur Verfügung gestellt werden.

Durch die in Anspruch 1 gekennzeichneten Elektronentransportschicht und Lochtransportschicht können insbesondere mit einer so charakterisierten Lochtransportschicht besonders zuverlässig die gewünschten elektrischen Eigenschaften erreicht werden, bei gleichzeitiger Erzielung der für eine hohe Lebensdauer benötigten Barriereeigenschaften des Schichtsystems. Des Weiteren wird hierdurch der Herstellungsprozess erleichtert und die Kosten der Herstellung werden gesenkt.

In einer bevorzugten Ausführungsform der Erfindung ist das optoelektronische Bauelement dadurch gekennzeichnet, dass die mindestens eine Elektronentransportschicht eine Elektronenmobilität zwischen 10⁻⁶ cm²/(V*s) und 100 cm²/(V*s) und bevorzugt ein LUMO zwischen 3 - 4 eV aufweist und die mindestens eine Lochtransportschicht eine Lochmobilität zwischen 10⁻⁶ cm²/(V*s) und 100 cm²/(V*s) und bevorzugt ein HOMO zwischen 5 und 7 eV aufweist.

Die Mobilität der Ladungsträger, d.h. bevorzugt die Mobilität der Elektronen (Elektronenmobilität) und die Mobilität der Löcher (Lochmobilität), bezeichnet bevorzugt den linearen Proportionalitätsfaktor zwischen der Driftgeschwindigkeit der Ladungsträger und einem elektrischen Feld. Diese Ladungsträgermobilität ist eine Materialeigenschaft und in der Regel von der Temperatur abhängig. Die vorgenannten Parameter gelten bevorzugt für eine Raumtemperatur von 25 °C, bei welcher das Bauelement bevorzugt zum Einsatz kommt. Durch die genannten Ladungsmobilitätwerte werden die Ladungsträger besonders effektiv zur Rekombinationszone (im Falle von Leuchtdioden) oder zu den Elektroden (im Falle von Solarzellen) transportiert. Dadurch können besonders effiziente Leuchtdioden bzw. Solarzellen produziert werden. Auch kann die Wärmeentwicklung im Betrieb verringert und so die Zuverlässigkeit erhöht werden.

Das LUMO (engl. *lowest unoccupied molecular orbit*) bezeichnet das niedrigste unbesetzte Orbital der Moleküle der Elektronentransportschicht, in welchem sich die Elektronen als freie Ladungsträger bewegen können. Während das HOMO (engl. *highest occupied molecular orbit*) das höchste besetzte Orbital der Moleküle der Lochtransportschicht bezeichnet, in welchem sich die Löcher als freie Ladungsträger bewegen können. Die vorgenannten Parameter für das LUMO und HOMO sind auf die Energiebänder der optisch aktive Schichten optimiert, welche bevorzugt entweder elektromagnetische Strahlung im sichtbaren Bereich emittieren oder absorbieren.

Besonders durch die Auswahl geeigneter Materialien und Schichtdicken, welche für die mindestens eine Elektronen- bzw. Lochtransportschicht zum einen zu den vorgenannten elektrischen Eigenschaften, zum anderen zu den gewünschten Barriereeigenschaften führt, kann ein Bauelement mit den gewünschten optoelektronischen Eigenschaften realisiert werden, welches gleichzeitig eine lange Lebensdauer aufweist. Des Weiteren kann die Leistungsfähigkeit des Bauelements erhöht werden.

Erfindungsgemäß ist das optoelektronisches Bauelement dadurch gekennzeichnet, dass die mindestens eine Elektronentransportschicht ein dotiertes Metalloxid, bevorzugt ein dotiertes Zinkoxid umfasst, wobei die Dotierung bevorzugt mit Aluminium, Alkali, Erdalkali, Metallocenen und/oder organischen n-Dotanten erfolgt und die Elektronentransportschicht besonders bevorzugt ein Aluminiumzinkoxid umfasst. Überraschenderweise zeichnen sich Elektronentransportschichten aus diesen Materialien, insbesondere aus einem dotierten Aluminiumzinkoxid, durch eine besonders gute Diffusionsbarriere gegenüber Wasser- und Sauerstoffmolekülen aus und weisen durch die Dotierung zudem optimale elektrische Eigenschaften auf. Es ist besonders bevorzugt, dass die Elektronentransportschicht aus einem der vorgenannten Materialien besteht und dabei ein LUMO zwischen 3 - 4 eV und Elektronenmobilität zwischen 10⁻⁶ cm²/(V*s) und 100 cm²/(V*s) aufweist. Dem Fachmann ist bekannt, wie er Materialien mit den genannten Parametern, ohne erfinderisch tätig zu werden, bereitstellen kann.

Erfindungsgemäß ist das optoelektronische Bauelement dadurch gekennzeichnet, dass die mindestens eine Lochtransportschicht ein dotiertes Metallthiocyanat, bevorzugt ein dotiertes Kupferthiocyanat und/oder ein dotiertes Metalloxid, bevorzugt ein dotiertes Zinkoxid umfasst. Diese Materialien lassen sich durch eine entsprechende Dotierung besonders vorteilhaft an die gewünschten Eigenschaften passen. Außerdem verfügen sie über die gewünschten Barriereeigenschaften gegenüber Sauerstoff und Wasser. Des Weiteren sind diese Materialien sehr robust und tragen so zur Herstellung eines zuverlässigen Bauelements bei. Bevorzugt werden die Materialien dotiert mit einem Metallthiocyanat. Metallthiocyanate eignen sich besonders gut zum Dotieren. Darüber hinaus ist mit ihnen ein breites Spektrum an durch Dotierung eingestellten Eigenschaften erzielbar. Die Metallthiocyanate werden bevorzugt ausgewählt aus einer Gruppe umfassend Natriumthiocyanat, Kaliumthiocyanat, Silberthiocyanat, Wolframthiocyanat, Vanadiumthiocyanat, Molybdänthiocyanat, Kupferthiocyanat und/oder anderen Übergangsmetallthiocyanaten. Dotierungen ausgewählt aus vorstehender Gruppe erlauben das zielgenaue Einstellen gewünschter elektrische Eigenschaften. Im Einzelfall können sogar synergistische Effekte aufgrund einer weiteren Verbesserung der ohnehin guten Barriereeigenschaften des dotierten Grundmaterials erzielt werden. Es kann ebenso vorteilhaft sein, mit einem Metalloxid zum dotieren. Metalloxide zeichnen sich durch eine besonders unkomplizierte und daher zuverlässige Verarbeitbarkeit aus. Bevorzugt werden zur Dotierung Metalloxide ausgewählt aus einer Gruppe umfassend Wolframoxid, Vanadiumoxid, Nickeloxid, Kupferoxid, Molybdänoxid und/oder anderen Übergangsmetalloxiden verwendet. Diese zeichnen sich beim Dotieren durch eine große Effektivität aus. Zu Ihrer Verarbeitung sind nur wenige Arbeitsschritte nötig. Es kann aber auch bevorzugt sein, mit Halogenen wie Fluor, Chlor, Brom und lod zu dotieren. Diese zeichnen sich durch ihre ausgeprägte chemische Reaktivität sowie durch ihre hohen Vorkommen in der Natur aus.

Für die Lochtransportschicht wird somit ein Metallthiocyanat, besonders bevorzugt ein Kupferthiocyanat oder aber ein Metalloxid, besonders bevorzugt ein Zinkoxid, dotiert. Der Fachmann weiß, dass eine Dotierung im Kontext von optoelektronischen Bauelementen bevorzugt das Einbringen von Fremdatomen, den Dotanten, in eine Schicht meint, wobei die eingebrachte Menge in der Regel im Vergleich zum Trägermaterial geringer ist. D.h. es kann bevorzugt sein, dass der Masseanteil der Dotanten weniger als 10%, bevorzugt weniger als 1%, der Gesamtschicht beträgt. Es kann aber auch bevorzugt sein, dass der Masseanteil der Dotanten bis zu 40% der Gesamtschicht beträgt. Bei der sogenannten p-Dotierung werden ElektronenAkzeptoren dotiert, wohingegen bei der sogenannten n-Dotierung ElektronenDonatoren dotiert werden. Für die Lochtransportschicht ist es bevorzugt, Materialien auszuwählen, welche starke Akzeptoreigenschaften aufweisen und bevorzugt ein LUMO in der Nähe des HOMOs von dem Träger des Metallthiocyanat oder Metalloxids, bevorzugt des Kupferthiocyanats oder Zinkoxids, aufweisen. Ein organischer p-Dotant kann bevorzugt zum Beispiel auch Tetrafluorotetracyanochinodimethan oder auch Hexaazatriphenylenehexacarbonitrile sein. Diese haben sich als besonders brauchbar erwiesen. Sie können zur weiteren Vorteilen wie höhere Leistungsfähigkeit und Zuverlässigkeit sowie zu einer hohen Ausbeute führen.

Es ist besonders bevorzugt, als Träger der Lochtransportschicht Kupferthiocyanat oder Zinkoxid zu verwenden mit den o.g. geeigneten Dotanten.

Es war überraschend, dass mit den vorgenannten Materialien für die Lochtransportschichten, insbesondere unter Verwendung von Kupferthiocyanat oder Zinkoxid, besonders effektiv eine Permeation von Wasser oder Sauerstoff verhindert werden kann, bei gleichzeitig ausgezeichneten elektrischen Eigenschaften zum Transport der Elektronenlöcher. Es ist besonders bevorzugt, dass durch die Dotierung das Lochtransportband eine Mobilität der Löcher zwischen 10⁻⁶ cm²/(V*s) und 100 cm²/(V*s) aufweist und der Träger und die Dotanten so ausgewählt werden, dass das HOMO des Lochtransportbandes zwischen 5 eV und 7 eV beträgt. So kann das optisch aktive Bauelement besonders zuverlässig und effektiv betrieben werden.

In einer bevorzugten Ausführungsform der Erfindung ist das optoelektronische Bauelement dadurch gekennzeichnet, dass die mindestens eine Elektronentransportschicht eine Gesamtschichtdicke von 10 - 50 nm aufweist, welche besonders robust und zuverlässig ist. Dabei ist bevorzugt, dass sie eine Gesamtschichtdicke von 25 - 30 nm aufweist. Diese hat sich als besonders wartungsfrei und leicht herstellbar herausgestellt, wodurch Kosten gesenkt werden. Die mindestens eine Lochtransportschicht umfasst eine Gesamtschichtdicke von 10 - 40 nm, welche ebenfalls besonders robust und zuverlässig ist. Dabei ist eine Gesamtschichtdicke von 10 - 30 nm bevorzugt. Diese hat sich ebenfalls als besonders wartungsfrei und leicht herstellbar herausgestellt und senkt daher die Kosten. Es ist besonders bevorzugt, dass die Gesamtschichtdicke der Lochtransportschicht eine Dicke von 15 - 25 nm aufweist. Diese stellt eine Verbesserung der elektrischen Eigenschaften dar. Die Gesamtschichtdicke bezeichnet bevorzugt die Dicke aller Elektronen- bzw. Lochtransportschichten. Im Falle der Verwendung jeweils einer Elektronen- bzw. Lochtransportschicht entspricht die Dicke der Dicke der Elektronen- bzw. Lochtransportschicht. Im Sinne der Erfindung bezeichnet die Dicke bevorzugt die Ausdehnung einer Schicht entlang des Schichtaufbaus zwischen den Elektroden und entlang des Ladungsträgertransports. Die vorgenannten Parameter sind vorteilhafterweise darauf optimiert einerseits einen effektiven Schutz der optisch aktiven Schicht, insbesondere vor Sauerstoff und Wasser, und andererseits einen besonders dünnen Gesamtaufbau des optoelektronischen Bauelementes umzusetzen. Hierdurch kann ein besonders langlebiges und dennoch dünnes, biegsames Bauelement bereitgestellt werden. Des Weiteren wird die Zuverlässigkeit erhöht, und es kann eine besondere ästhetische Wirkung aufgrund der dünnen, nicht sichtbaren Schichten erzielt werden. Diese tragen synergistisch zur ästhetischen Wirkung bei einem emittierenden Bauelement auch dadurch bei, dass die Lichttransmission der Schichten erhöht und deren Streuung vermindert wird.

Erfindungsgemäß ist das optoelektronische Bauelement dadurch gekennzeichnet, dass die mindestens eine Elektroneninjektionsschicht oder -extraktionsschicht und die mindestens eine Lochinjektionsschicht oder -extraktionsschicht eine Sauerstofftransmissionsrate (OTR) von weniger als 1 cm³/(m²*d) und eine Wasserdampftransmissionsrate (WVTR) von weniger als 1 g/(m²*d) aufweist. Weisen diese äußeren Schichten des Bauelements vorgenannte Eigenschaften auf, kann ein besonders effektiver Schutz der inneren Elemente gewährleistet werden. Dieser Schutz wirkt sich schon während der Herstellung, wenn das Bauelements nach besonders empfindlich ist, positiv aus und erhöht die Zuverlässigkeit.

In dem Bauelement kann es aufgrund von Nanodefekten in den Elektroden zu einem Einströmen von Wasser- und Sauerstoffmolekülen in das Bauelement kommen. Erfindungsgemäß ist es bevorzugt, dass die Transportschichten für die Ladungsträger eine Diffusionsbarriere für diese Permeanten darstellen. Die Injektions- bzw. Extraktionsschichten liegen bevorzugt zwischen den Elektroden und den Transportschichten und sind bevorzugt diffusionslimitierend. Mit den vorgenannten Parametern für die OTR und WVTR der Injektions- bzw. Extraktionsschichten lässt sich eine besonders gute Einschränkung der Diffusion von Wasser und Sauerstoff erreichen. Hierdurch werden die Weglängen der Moleküle stark verlängert, sodass ein Austritt - z. B. durch einen Defekt in den Elektroden - deutlich wahrscheinlicher wird, als ein Diffundieren hin zu der empfindlichen optisch aktiven Schicht. Die bevorzugte Ausführungsform erhöht hierdurch in besonderem Maße die Lebensdauer des Bauelementes. Durch die diffusionslimitierenden Eigenschaften der Injektions- bzw. extraktionsschichten in Kombination mit der durch die Transportschichten realisierten Diffusionsbarriere kann ein besonders effektiver Schutz der optisch aktiven Schicht realisiert werden. Der Diffusionsschutz, welcher aus der Kombination der Schichten resultiert, ist überraschend höher als ein einzig durch die Transportschichten herbeigeführter Schutz. Dieser Effekt ist, wie bereits weiter oben dargelegt wurde, synergistisch, d. h. der Schutz ist erheblich stärker, als sich durch die Summe der Schutzwirkungen der einzelnen Schichten erwarten ließe.

Erfindungsgemäß ist das optoelektronische Bauelement dadurch gekennzeichnet, dass die mindestens eine Elektroneninjektionsschicht oder -extraktionsschicht dielektrische Polymere umfasst. Diese weisen sich durch eine besondere Robustheit aus, wodurch ein langlebiges Bauteil erzeugt werden kann. Durch ihre guten Barriereeigenschaften entstehen Synergien, die sich darüber hinaus positiv auf die Langlebigkeit auswirken. Es ist besonders bevorzugt, hydrophile Polymere und/oder Polyelektrolyte zu verwenden. Diese lassen besonders leicht verarbeiten und bedeuten so eine Ersparnis an Zeit Material und Arbeitsstufen und dementsprechend an Kosten. Ganz besonders bevorzugt sind Polymere ausgewählt aus einer Gruppe umfassend Poly-Oxazoline, Polymethacrylate, Polyacrylamide, Polyethylenoxide, Polyacrylsäuren, Polyacrylate, Polyvinylpyrolidon sowie Co-Polymere dieser Gruppe. Diese haben sich als besonders brauchbar erwiesen und zeichnen sich durch überlegene elektrische Eigenschaften aus. Insbesondere ist der Gebrauch von Polyvinylalkohol, Polyethylenimin oder ethoxyliertes Polyethylenimin bevorzugt, denn sie führen zu einer weiteren Verbesserung und Leistungssteigerung des Bauelements.

Die vorgenannten Materialien sind besonders geeignet, um die elektrische Funktion der Injektions- bzw. Extraktionsschichten für Elektronen zu gewährleisten. So können die Elektronen als Ladungsträger den Quanteneffekt des "Tunnelns" nutzen und entweder von der Kathode in die Elektronentransportschicht (im Falle der Elektroneninjektionsschicht) oder von der Elektronentransportschicht zur Kathode (im Falle der Elektronenextraktionsschicht) springen. Die vorgenannten dielektrischen Polymere erzeugen bevorzugt entsprechende Oberflächendipole und vermindern so die Injektionsbarriere für Elektronen. Gleichermaßen wird die Beweglichkeit von Sauerstoff- und Wassermolekülen in den Schichten überraschend stark vermindert bzw. eingeschränkt. Somit erlauben die vorgenannten Materialien die bevorzugten Werte für die OTR von weniger als 1 cm³/(m²*d) und für die WVTR von weniger als 1 g/(m²*d) besonders zuverlässig umzusetzen.

Erfindungsgemäß ist das optoelektronische Bauelement dadurch gekennzeichnet, dass die mindestens eine Lochinjektionsschicht oder -extraktionsschicht dielektrische Polymere umfasst. Diese weisen überlegene Barriereeigenschaften auf und erhöhen so die Zuverlässigkeit. Diese sind bevorzugt Polymere mit funktionellen Gruppen ausgewählt aus eine Gruppe umfassend -CN, -SCN, -F, -Cl, -I und/oder -Br, welche besonders robust und wartungsfrei sind. Dabei umfasst die mindestens eine Lochinjektionsschicht oder -extraktionsschicht besonders bevorzugt Polyvinylidenefluorid (PVDF), Polyvinylidenechlorid (PVDC), Polyacrylonitril (PAN) und/oder Co-Polymere dieser, welche eine Verbesserung und Leistungssteigerung des Bauelements bewirken.

Die vorgenannten Materialien sind besonders geeignet, um die elektrische Funktion der Injektions- bzw. Extraktionsschichten für Elektronenlöcher zu gewährleisten. Insbesondere erfüllen die vorgenannten Polymere die bevorzugte Injektionseigenschaft d.h. eine Erhöhung der Austrittsarbeit für Elektronen an den Kontaktflächen zur Injektionsschicht und damit eine effektive Lochinjektion. Weiterhin haben die Materialien auch ausgezeichnete Barriereeigenschaften gegenüber Wasser und Sauerstoff. Teilweise werden die vorgenannten Materialien bereits als Lebensmittelfolien eingesetzt. Es war überraschend, dass mit Hilfe dieser Materialien Injektions- bzw. Extraktionsschichten für Elektronenlöcher bereitgestellt werden können, welche sowohl eine besonders energieeffiziente Funktion des Bauelementes als auch eine besonders lange Lebensdauer gewährleisten.

In einer weiteren bevorzugten Ausführungsform ist das optoelektronische Bauelement dadurch gekennzeichnet, dass die mindestens eine Elektroneninjektionsschicht oder - extraktionsschicht eine Gesamtschichtdicke zwischen 0,1 nm und 10 nm aufweist. Eine solche Schichtdicke lässt sich besonders zuverlässig verarbeiten und trägt zur Verbesserung der elektrischen und optischen Eigenschaften bei. Besonders bevorzugt ist eine Schichtdicke zwischen 5 nm und 7 nm, da hier ein idealer Kompromiss zwischen gewünschten optischen und elektrischen Eigenschaften einerseits und einer Qualitätshebung des Herstellungsverfahrens andererseits vorliegt. Für die mindestens eine Lochinjektionsschicht oder -extraktionsschicht ist eine Gesamtschichtdicke zwischen 0,1 nm und 10 nm bevorzugt. Die vorgenannt für die Elektroneninjektions- bzw. -extraktionsschicht geltenden Vorteile treffen hier analog zu. Dies gilt ebenso für die besonders bevorzugte Schichtdicke zwischen 5 nm und 7 nm. Die Gesamtschichtdicke quantifiziert bevorzugt die gesamte Ausdehnung jeweils aller Elektroneninjektionsschicht oder -extraktionsschichten bzw. jeweils aller Lochinjektionsschicht oder -extraktionsschicht. Im Falle einer Schicht ist die Gesamtschichtdicke bevorzugt gleich der Dicke der Schicht, andernfalls gleich der Summe der Dicke der einzelnen Schichten. Es wurde von den Erfindern erkannt, dass die vorgenannten Schichtdicken überraschenderweise sowohl ausgezeichnete Blockadeeigenschaften gegenüber Wasser und Sauerstoff erlauben, als auch eine effektives "Tunneln", wodurch die elektrische Funktion erfüllt wird.

In einer weiteren bevorzugten Ausführungsform der Erfindung ist das optoelektronisches Bauelement dadurch gekennzeichnet, dass das Bauelement mindestens zwei Elektroneninjektionsschichten oder -extraktionsschichten, mindestens zwei Elektronentransportschichten, mindestens zwei Lochtransportschichten und mindestens zwei Lochinjektionsschichten oder - extraktionsschichten umfasst, wobei die Elektroneninjektionsschichten oder - extraktionsschichten und die Elektronentransportschichten sowie die Lochinjektionsschichten oder -extraktionsschichten und die Lochtransportschichten alternierend angeordnet vorliegen. Im Sinne der Erfindung wird unter der alternierenden Anordnung bevorzugt verstanden, dass sich die Injektions- bzw. Extraktionsschichten bevorzugt mit den Transportschichten abwechseln. Zum Beispiel wäre ein bevorzugter Schichtaufbau für zwei Elektronentransportschichten und zwei Elektroneninjektionsschichten wie folgt: an die Kathode grenzt die erste Injektionsschicht, gefolgt von der ersten Transportschicht, der zweiten Injektionsschicht und der zweiten Transportschicht, welche an die optisch aktive Schicht grenzt. Durch die bevorzugte Verwendung von mehreren Injektions- und Transportschichten kann ein besonders effektiver Schutz vor einer Permeation von Wasser und Sauerstoff erreicht werden. Durch die alternierende Anordnung kommt es zu einer überraschenden Erhöhung der Blockadeeigenschaften der Schichten auch bei einer geringen Dicke der einzelnen Schichten. Dieser synergistische Effekt insbesondere bei einer alternierenden Anordnung der Schichten ist größer als durch die Summe der Blockadeeigenschaften der einzelnen Schichten anzunehmen wäre.

In einer weiteren bevorzugten Ausführungsform der Erfindung ist das optoelektronische Bauelement dadurch gekennzeichnet, dass die Anode Metalle, Metalloxide, Metallthiocyanate, Metallnanodrähten und/oder Mischungen dieser Materialien umfasst. Diese Materialien haben den Vorteil, dass sie besonders leicht zu verarbeiten sind. Bevorzugterweise sind die Metallnanodrähte Silbernanodrähte und/oder Metalloxidnanodrähte. Diese haben besonders exzellente optische und elektrische Eigenschaften und sorgen somit für eine Verbesserung und Leistungssteigerung des Bauelements. Die Metalloxide sind bevorzugt Übergangsmetalloxide oder mit Metallen und/oder Halogenen dotierte Metalloxide. Diese zeichnen sich durch eine besonders hohe Austrittsarbeit aus und verbessern die Effektivität des Bauelements. Von den vorgenannten Materialien sind besonders bevorzugt Indium-Zinn-Oxid und/oder fluoriertes Zinkoxid. Diese Materialien sind besonders robust und erhöhen so die Zuverlässigkeit. Die Metallthiocyanate sind bevorzugt Übergangsmetallthiocyanate, da Sie leicht verarbeiten sind und somit die Kosten senken. Besonders bevorzugt sind dabei Wolframthiocyanate und/oder Kupferthiocyanate. Diese Materialien haben sich als besonders wartungsfrei herausgestellt und erhöhen die Lebensdauer. Außerdem sind sie gut elektrisch kontaktierbar.

Alle vorgenannten Materialien erfüllen besonders gut die Funktionalität der Anode, als Lieferant von Elektronenlöchern zu dienen und eine hohe Austrittsarbeit sowie Flächenleitfähigkeit für Elektronenlöcher aufzuweisen. Besonders bevorzugt kann zudem das Anodenmaterial derart gewählt werden, dass es transparent für sichtbares Licht ist, da vorzugsweise durch die Anode der Austritt der elektromagnetisch erzeugten Strahlung (im Falle von Leuchtdioden) erfolgt. Zudem weisen die Materialien bevorzugt Blockadeeigenschaften gegenüber Wasser oder Sauerstoff auf, sodass die gesamt OTR bzw. WVTR einer Kombination aus Elektrode, Injektions- bzw. Extraktionsschichten sowie Transportschichten bevorzugt weniger als 0,01 cm³/(m²*d) bzw. 0,01 g/(m²*d) beträgt.

Es kann aber ebenso bevorzugt sein, dass die gesamt OTR bzw. WVTR einer Kombination aus Elektrode, Injektions- bzw. Extraktionsschichten sowie Transportschichten bevorzugt weniger als 0,1 cm³/(m²*d) bzw. 0, 1 g/(m²*d) beträgt. Die gewünschten OTR- bzw. WVTR-Eigenschaften können durch eine geeignete Schichtdicke des Anodenmaterials sowie durch Material und Dicke der anderen Schichten entsprechend beeinflusst werden.

Besonders bevorzugt besteht die Anode aus einem mit Indium dotierten Zinn-Oxid (engl. *indium-tin-oxide;* ITO) mit einer besonders bevorzugten Schichtdicke von ca. 150 nm Dicke. Im Sinne der Erfindung wird unter Angaben wie ca., ungefähr oder synonymen Begriffen bevorzugt eine Toleranz von ± 10%, besonders bevorzugt ± 5% verstanden. In einer weiteren besonders bevorzugten Variante wird zudem eine dünne Silberschicht auf dem ITO aufgebracht (bevorzugt mit einer Schichtdicke von ca. 2 nm). Dies erhöht die Leitfähigkeit noch zusätzlich. In einer weiteren bevorzugten Variante besteht die Anode aus einer Schicht von ITO von ca. 150 nm, einer Silberschicht von ca. 2 nm und zusätzlich einer Schicht aus Wolframtrioxid (WOs mit einer Schichtdicke von bevorzugt ca. 2 nm). Vorteilhafterweise erlaubt das Aufbringen dieser Metallschichten eine gute Bereitstellung von Elektronenlöcher. Weiterhin sind die Materialien bei Schichtdicken von 1 nm bis 5 nm hochtransparent. Durch die höhere Austrittsarbeit des Wolframtrioxid im Vergleich zu Silber kann die bevorzugte Leuchtdiode mit einer besonders niedrigeren Betriebsspannung betrieben werden. Weiterhin kann es auch bevorzugt sein, insbesondere für die vorgehend genannten Ausführungsformen, das ITO durch ein mit Fluor dotiertes Zinnoxid (engl. *Fluorine Tin oxide*, FTO) oder ein mit Chlor dotiertes Zinnoxid (engl. *Chlorine tin oxide,* CTO) oder ein mit Chlor dotiertes Zinkoxid (engl. *Chlorine zinc oxide,* CZO) oder ein mit Fluor dotiertes Zinkoxid (engl. *Fluorine zinc oxide, FZO*) oder mit Metallnanodrähten bevorzugt Silbernanodrähte eingebettet in eine Matrix aus FTO, CTO, CZO oder FZO zu ersetzen. Durch ihre bevorzugten optischen Eigenschaften tragen vorgenannten Materialien zur Leistungssteigerung des Bauelements bei. Ebenso wird durch die so bewirkte gesteigerte Brillanz und die verringerte Streuung eine besondere ästhetische Wirkung erzielt.

In einer bevorzugten Ausführungsform ist das optoelektronisches Bauelement dadurch gekennzeichnet, dass die Anode eine Schichtdicke zwischen 50 und 500 nm besitzt. Hierdurch lässt sich eine kompakte und flexible Bauweise des optoelektronischen Bauelementes umsetzen, welches die gewünschten optischen Eigenschaften besitzt. Ebenso können so die gewünschten OTR- bzw. WVTR-Eigenschaften des gesamten Schichtsystems erreicht werden. Des Weiteren wird die elektrische Kontaktierung der Anode durch die genannte Schichtdicke erleichtert und die dafür erforderliche, mechanische Stabilität der Anode ist gegeben.

In einer bevorzugten Ausführungsform ist das optoelektronisches Bauelement dadurch gekennzeichnet, dass die Kathode Metalle, Metalloxide, Metallthiocyanate, Metallnanodrähten und/oder Mischungen dieser Materialien umfasst. Diese Materialen sind besonders robust und wartungsfrei. Dabei werden die Metalle bevorzugt ausgewählt aus einer Gruppe umfassend Aluminium, Kupfer, Gallium, Indium, Zinn, Kobalt, Nickel, welche eine gute Verarbeitbarkeit aufweisen und so die Herstellung vereinfachen. Die Metallnanodrähte sind bevorzugt Silbernanodrähte und/oder Metalloxidnanodrähte, welche die Leistungsfähigkeit des Bauelements verbessern. Die Kathode umfasst besonders bevorzugt mit Metallen dotierte Metalloxide, welche die Qualität des Bauteils heben. Besonders bevorzugt umfasst die Kathode ein mit Aluminium dotiertes Zinkoxid, welches eine Verbesserung der elektrischen Eigenschaften erlaubt.

Diese Materialien erlauben die Optimierung der Austrittsarbeit der Kathode und insbesondere eine optimale Bereitstellung von Elektronen im Falle von Leuchtdioden. So lässt sich ein besonders geringer Flächenwiderstand realisieren, um eine möglichst gleichmäßige Injektion der Elektronen über die Fläche der Kathode zu ermöglichen.

Besonders bevorzugt besteht die Kathode aus einer Metallschicht, bevorzugt Silber, die vorzugsweise gedruckt wurde. Dies bedeutet bei der Herstellung eine Ersparnis an Zeit, Material und Arbeitsstufen und somit eine Verringerung der Kosten. Ebenso besitzt Silber im sichtbaren Wellenlängenbereich ideale optische (Reflektions-) Eigenschaften. Es kann aber auch alternativ bevorzugt sein das Metall aufzudampfen. Das Aufdampfen von Metall bietet bei der Herstellung eine erhöhte Zuverlässigkeit. Neben Silber können bevorzugt auch weitere Metalle wie Aluminium, Kupfer, Galinstan oder Legierungen verwandt werden. Diese Rohstoffe zeichnen sich durch gute Verarbeitbarkeit aus. Die Dicke der Kathode beträgt für diese Materialien vorzugsweise zwischen 50 nm bis 500 nm. Kathoden dieser Dicke können besonders zuverlässig hergestellt werden. Besonders bevorzugt ist eine Schichtdicke der Kathode von ca. 150 nm. Eine Kathode dieser Dicke ist besonders effektiv.

In einer weiteren bevorzugten Variante besteht die Kathode aus einer Schicht aus Metallnanodrähten, die gedruckt wurde. Eine solche Kathode kann besonders zuverlässig und kostengünstig erzeugt werden. Vorzugsweise handelt es sich um Silbernanodrähte. Diese tragen zu einer Leistungssteigerung, vor allem durch die günstigen optischen und elektrischen Eigenschaften. Alternativ kann es bevorzugt sein, Kupfer-, Kobalt- oder Nickeldrähte zu verwenden. Diese sind besonders gut verarbeitbar und erhöhen die Zuverlässigkeit. Die Schicht aus Metallnanodrähten hat vorzugsweise ebenfalls eine Dicke zwischen 30 bis 500 nm, welche besonders zuverlässig hergestellt werden kann, sehr robust ist und besonders einfach elektrisch kontaktiert werden kann. Besonders bevorzugt ist eine Schichtdicke von ca. 150 nm. Diese kann besonders fehlerfrei hergestellt werden. Es kann bevorzugt sein, dass die Metallnanodrähte in eine Metalloxidmatrix aus Aluminium dotiertem Zinkoxid eingebettet sind. So können besonders vorteilhafte elektrische Eigenschaften erzielt werden. Es kann besonders bevorzugt sein, dass die Kathode transparent ist. Zusammen mit einer bevorzugt transparenten Anode, kann eine besonders transparente Leuchtdiode bereitgestellt werden. Durch das beidseitige Abstrahlverhalten wird eine besonders ästhetische Wirkung und ein überraschender Effekt, der beispielsweise in der Printwerbung genutzt werden kann, erzielt.

Des Weiteren können durch die genannten Materialien und Dicken der Kathode die gewünschten OTR- bzw. WVTR-Eigenschaften des die Kathode umfassenden Schichtsystems erzielt werden.

Es kann weiterhin bevorzugt sein auf die Metallnanodrähte der Kathode eine Metallfolie aufzukleben. Dadurch erhält man eine erhöhte Reflektion und somit einen erhöhten Lichtaustritt aus der transparenten Anode. Die Metallfolie kann vorzugsweise eine handelsübliche Aluminiumfolie sein mit einer Dicke von ca. 50 µm. So können Kosten reduziert werden. Die Metallfolie kann aber auch eine Dicke in einem Bereich von 10 µm bis 100 µm besitzen. Der Vorteil dieser Ausführungsform ist die Flexibilität, gewünschte Eigenschaften bezüglich Robustheitsgrad, Reflektionsgrad und Flexibilität des Bauelements auszuwählen. Weiterhin kann es sich bei der bevorzugt verwandten Metallfolie auch um Kupfer oder andere Metalle handeln. So kann die Lichtausbeute erhöht und angepasst werden.

In einer weiteren bevorzugten Ausführungsform ist das optoelektronische Bauelement dadurch gekennzeichnet, dass die Kathode eine Schichtdicke zwischen 50 nm und 500 nm aufweist. So wird ein weiteres Mittel zur umfangreichen Beeinflussung der elektrischen und optischen Eigenschaften bereitgestellt. Bevorzugt soll die Kathode eine Schichtdicke zwischen 100 nm und 200 nm aufweisen. Eine solche Katode hat sich als besonders robust und zuverlässig erwiesen.

In einer bevorzugten Ausführungsform der Erfindung ist das optoelektronische Bauelement dadurch gekennzeichnet, dass die optisch aktive Schicht eine Emitterschicht ist mit einem Emissionsspektrum bevorzugt in einem Wellenlängenbereich zwischen 400 nm und 700 nm. Die lichterzeugende Schicht besteht bevorzugt aus halbleitenden organischen Polymeren oder Molekülen, die bei elektrischer Anregung, d.h. dem Anlegen von Spannung an den Elektroden, Licht im sichtbaren Bereich, bevorzugt zwischen 400 nm und 700 nm generieren. Bevorzugt hat die Emitterschicht eine Dicke von 15 nm bis 100 nm. So kann eine Leistungssteigerung der lichterzeugenden Schicht bezüglich ihrer Effizienz und der generellen optischen Eigenschaften erreicht werden. Besonders bevorzugt weist die Emitterschicht eine Dicke von 40 - 60 nm auf. Eine solche Emitterschicht arbeitet sehr zuverlässig und wartungsfrei. In einer bevorzugten Variante besteht die lichterzeugende Schicht aus 95% Masseanteil eines Polymers, welches unter elektrischen Anregung Licht im sichtbaren Spektrum erzeugt, und 5% Masseanteil eines Polymers, welches eine höhere Bandlücke hat als das lichterzeugende Polymer. Bei dieser bevorzugten Variante kann monochromatisches Licht erzeugt werden. In einer weiteren bevorzugten Ausführungsform besteht die Emitterschicht zu 100% aus einem Polymer, welches unter elektrischer Anregung Licht im sichtbaren Bereich erzeugt. Eine solche Emitterschicht ist besonders robust. Weiterhin kann die Emitterschicht bevorzugt mit diversen Dotierungen zur Erhöhung der Leitfähigkeit und somit Verbesserung der Effizienz (z.B. Aluminiumchinolat, Tetrafluorotetracyanochinodimethan, Molybdeniumoxid Nanopartikel, Metallocene) oder zur Veränderung des Emissionsspektrums und der Elektron-Photon Effizienz (z.B. Iridium-Chinolatkomplexe) aufweisen. Im Sinne der Erfindung können aber vorteilhafterweise ganz verschiedene Emitterschichten eingesetzt werden. Die Emitterschichten sind zumeist anfällig gegenüber Reaktionen mit Wasser oder Sauerstoff, sodass ihr Wirkungskoeffizient stark von der Exposition gegenüber diesen Molekülen abhängt. Durch die Bereitstellung eines optischen Bauelementes, welches die optisch aktive Schicht, wie die Emitterschicht, wirksam vor der Permeation von Wasser und Sauerstoff schützt, ist eine Verwendung und Anpassung verschiedenster Schichten für die jeweilige Anwendung möglich. Die bevorzugte Ausführungsform, welche im sichtbaren Spektrum emittiert, ist besonders für kommerzielle Anwendung geeignet.

In einer weiteren bevorzugten Ausführungsform ist das optoelektronische Bauelement dadurch gekennzeichnet, dass die optisch aktive Schicht eine Absorberschicht ist mit einem Absorptionsspektrum bevorzugt in einem Bereich zwischen 300 nm und 1500 nm. Als Absorberschicht können bevorzugt Polymerschichten verwandt werden, welche elektrischen Strahlung, bevorzugt Sonnenstrahlen, absorbieren und freie Elektronen-Loch-Paaren erzeugen. Durch die bevorzugt genannten Bereiche kann eine breite Ausnutzung der Sonnenergie für Solarzellen erzielt werden. Vorteilhafterweise können für die Absorberschicht viele aus dem Stand der Technik bekannte Materialien eingesetzt werden. Insbesondere treten Ausschlusskriterien bezüglich der Empfindlichkeit gegenüber Wasser oder Sauerstoff in Bezug auf eine Beeinträchtigung der Lebensdauer zurück, da die Blockadeeigenschaften der weiteren elektrischen Schichten die optisch aktive Schicht wirksam schützen.

Die Erfindung betrifft weiterhin ein Verfahren zur Herstellung eines erfindungsgemäßen optoelektronischen Bauelementes bzw. bevorzugter Ausführungsformen davon, wobei das Verfahren dadurch gekennzeichnet ist, dass die Elektroneninjektionsschicht, die Elektronentransportschicht, die optisch aktive Schicht, die Lochtransportschicht und/oder die Lochinjektionsschicht mit einem nasschemischen Verfahren und/oder einem thermischen Aufdampfverfahren aufgebracht werden. Solche Verfahren stellen eine Verbesserung gegenüber dem Stand der Technik dar und sind besonders zuverlässig. Es ist besonders bevorzugt, dass die Schichten durch Siebdruck, Aufschleudern, Offset-Druck, und/oder Gravurdruck aufgebracht werden. Diese Verfahren bedeuten ein Ersparnis an Zeit, Material, Arbeitsstunden und Kosten. Ganz besonders bevorzugt ist es, die Schichten mit Hilfe von einem Tintenstrahldruck-Verfahren aufzubringen. Dieses Verfahren ist besonders robust und effizient und bedeutet eine Qualitätshebung gegenüber herkömmlichen Verfahren. Die Kathode und Anode können besonders bevorzugt mit einem Aufsprühverfahren aufgebracht werden. Dieses Verfahren bietet eine erhöhte Zuverlässigkeit und eine Verbilligung der Herstellung.

Dabei ist besonders bevorzugt, dass die Transportschichten, sowie die Injektions- bzw. Extraktionsschichten stabil an Luft prozessierbar sind. Die vorig genannten Materialien sowie die hier genannten Verfahren zum Aufbringen der Schichten sind dafür besonders geeignet. Mit "stabil an Luft prozessierbar" ist hier insbesondere gemeint, dass alle zur Herstellung des Bauelements nötigen Schritte, insbesondere das Aufbringen der Schichten, ohne Einschränkung und besondere Vorsichtsmaßnahmen an der umgebenden Raumluft durchgeführt werden können. So können Kosten und Zeit bei der Herstellung gespart werden und die Effizienz gesteigert werden.

Bevorzugt werden unter den nasschemischen Verfahren Herstellungsverfahren verstanden, bei welchen die Materialien für die einzelnen Schichten, z.B. die Polymere, in Lösungen vorliegen und eine Beschichtung mit Hilfe dieser Lösungen erfolgt. Dem Fachmann sind geeignete Lösungsmittel als Träger für die jeweiligen Komponenten bekannt. Unter dem thermischen Aufdampfen werden bevorzugte vakuumbasierte Beschichtungsverfahren verstanden, wobei die Materialien für die Schichten zu einem Siedepunkt erhitzt werden und so auf die jeweiligen Substrate aufgedampft werden.

Durch die genannten Verfahren lassen sich besonders homogene, reine Schichten mit wohldefinierten Ausdehnungen applizieren. Das Tintenstrahldruckverfahren für die elektrischen Schichten sowie die optisch aktive Schicht und das Aufsprühverfahren für die Elektroden zeichnen sich zudem durch besonders geringere Herstellungskosten und eine breite Anwendbarkeit auf verschiedenen Substraten aus. Vor allem durch die Prozessierbarkeit der elektroaktiven Schichten an Luft kann das Verfahren ohne besonderen Aufwand realisiert werden, insbesondere ohne spezielle Vakuum- oder gasbefüllte Kammern zu verwenden.

Im Folgenden soll die Erfindung an Hand von Beispielen näher erläutert werden, ohne auf diese beschränkt zu sein.

### Kurzbeschreibung der Abbildungen

- Fig. 1: Schematische Abbildung des Schichtaufbaus eines herkömmlichen optoelektronischen Bauelementes, welches von einer Barrierefolie verkapselt ist.
- Fig. 2: Schematische Zoomansicht des Schichtaufbaus der Barrierefolie für ein herkömmliches optisches Bauelement
- Fig. 3: Schematische Abbildung einer bevorzugten Ausführungsform des erfindungsgemäßen optoelektronischen Bauelementes

### Detaillierte Beschreibung der Abbildungen

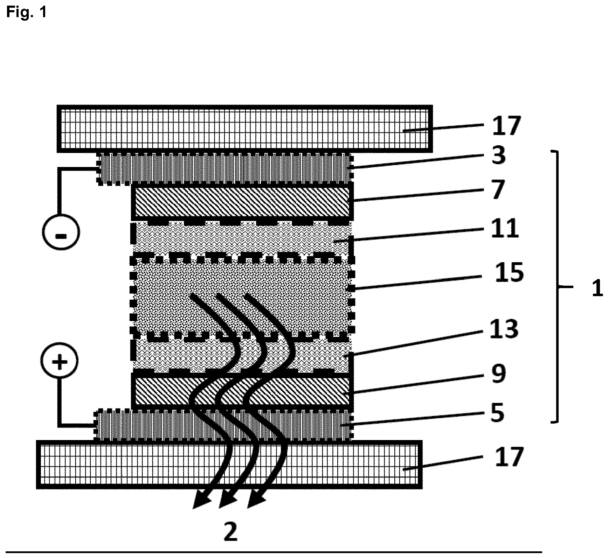

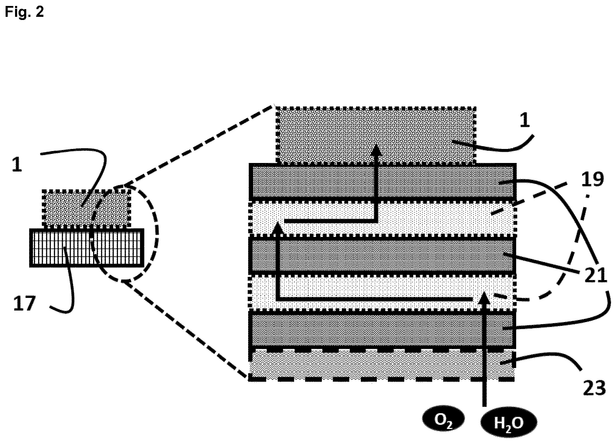

Fig. 1 und 2 zeigen den schematischen Aufbau eines herkömmlichen optoelektronischen Bauelementes 1, welches von einer Barrierefolie 17 umkapselt wird. Der Schichtaufbau für das dargestellte Bauelement 1 ist der einer Leuchtdiode und setzt sich wie folgt zusammen. Eine Kathode 3 dient der Bereitstellung von Elektronen während die Anode 5 Löcher liefert, sobald an diesen Elektroden eine Spannung angelegt wird. Die Vorzeichen + und - zeigen jeweils bevorzugt die Spannungsrichtung an. Die Eigenschaften der Elektroneninjektionsschicht 7 und der Lochinjektionsschicht 9 erlauben bevorzugt ein effizientes quantenmechanisches Tunneln der Ladungsträger zu den Transportschichten. Die Elektronentransportschicht 11 und die Lochtransportschicht 13 zeichnen sich durch eine hohe Beweglichkeit für die Ladungsträger aus und gewährleisten einen zielgerichteten Transport zur Emitterschicht 15. In der Emitterschicht 15 rekombinieren die Ladungsträger unter Erzeugung von Exzitonen und der Ausstrahlung von sichtbarem Licht 2. Das Eindringen von Wasser oder Sauerstoff in die Emitterschicht vermindert den Wirkungskoeffizienten und somit die Lebensdauer deutlich. Aus dem Grund wird im Stand der Technik das optoelektronische Bauelement 1 von einer Barrierefolie 17 umkapselt, welche ein Eindringen von Wasser und Sauerstoff verhindern soll. Zu diesem Zweck ist es im Stand der Technik üblich einen alternierenden Schichtaufbau zu wählen, bei dem sich diffusionslimitierenden Schichten 19 mit Diffusionsbarrieren oder Blockschichten 21 abwechseln. Die Diffusionsbarriere oder Blockschicht 21 soll die Diffusion der Moleküle verhindern. Es besteht jedoch die Möglichkeit, dass Moleküle durch kleine Defekte hindurch diffundieren. Durch die diffusionslimitierenden Schichten 19 wird die Wegelänge der Moleküle verlängert, sodass diese bevorzugt durch den Defekt in einer Diffusionsbarriere oder Blockschicht 21 wieder austreten. Die Barrierefolie umfasst weiterhin im Stand der Technik eine Trägersubstrat 23.

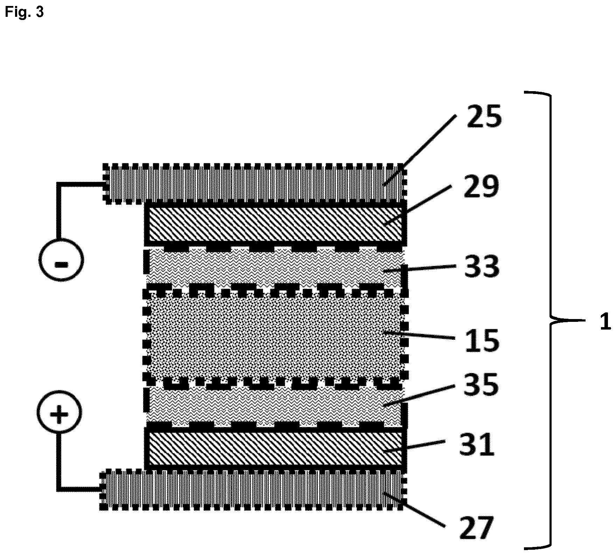

Fig. 3 zeigt eine schematische Abbildung einer bevorzugten Ausführungsform des erfindungsgemäßen optoelektronischen Bauelementes. Der Schichtaufbau für das dargestellte optoelektronische Bauelement 1 ist der einer Leuchtdiode. Die grundsätzlichen Funktionen der Schichten in dem Schichtaufbau gleichen dem für die herkömmlichen optoelektronischen Bauelemente gemäß der Fig. 1 oder 2. Eine Kathode 25 dient der Bereitstellung von Elektronen, während die Anode 27 Löcher liefert, sobald an diesen Elektroden eine Spannung angelegt wird. Die Vorzeichen + und - zeigen jeweils bevorzugt die Spannungsrichtung an. Zusätzlich weisen die Kathode 25 und die Anode 27 jedoch Blockadeeigenschaften gegenüber Wasser- und Sauerstoffmolekülen auf und stellen so eine Diffusionsbarriere für die Permeanten dar.

Die elektrischen Eigenschaften der Elektroneninjektionsschicht 29 und der Lochinjektionsschicht 31 erlauben bevorzugt ein effizientes quantenmechanisches Tunneln der Ladungsträger zu den Transportschichten. Gleichzeitig sind die Materialien der Elektroneninjektionsschicht 29 und der Lochinjektionsschicht 31 so gewählt, dass diese diffusionslimitierend auf Wasser- und Sauerstoffmoleküle wirken, sodass die Diffusionslänge der Moleküle in der jeweiligen Schicht verlängert wird.

Die Elektronentransportschicht 33 und die Lochtransportschicht 35 zeichnen sich durch eine hohe Beweglichkeit für die Ladungsträger aus und gewährleisten einen zielgerichteten Transport zur Emitterschicht 15. In der Emitterschicht 15 rekombinieren die Ladungsträger unter Erzeugung von Exzitonen und der Ausstrahlung von sichtbarem Licht 2.

Im Gegensatz zum Stand der Technik stellen die Elektronentransportschicht 33 und die Lochtransportschicht 35 jedoch eine Diffusionsbarriere gegenüber Wasser und Sauerstoff dar. Der erfindungsgemäße Schichtaufbau ermöglicht somit einen alternierenden Schichtaufbau von diffusionslimitierenden Schichten und Diffusionsbarrieren in Analogie zu der Barrierefolie aus dem Stand der Technik. Erfindungsgemäß wurde jedoch erkannt, dass elektrisch aktiven Schichten (Elektroneninjektionsschicht 29, Lochinjektionsschicht 31, Elektronentransportschicht 33 und Lochtransportschicht 35) sowie die Elektroden (Kathode 25 und Anode 27) selbst als diffusionslimitierende Schichten und Diffusionsbarrieren eingesetzt werden können. Die Elektronentransportschicht 33, die Lochtransportschicht 35, die Kathode 25 und die Anode 27 wirken dabei als Diffusionsbarrieren, welche das Diffundieren von Wasser- oder Sauerstoffmolekülen verhindern sollen. Die Elektroneninjektionsschicht 29 und Lochinjektionsschicht 31 fungieren als diffusionslimitierende Schichten, welche die Weglängen der Moleküle verlängern und somit Defekte der Diffusionsbarrieren ausgleichen können. In der bevorzugen Ausführungsform weist die Schichtkombination aus Kathode 25, diffusionslimitierende Elektroneninjektionsschicht 29 und Elektronentransportschicht als Diffusionsbarriere 33 einen OTR von weniger als 0,1 cm³/(m²*d), bevorzugt weniger als 0,01 cm³/(m²*d) und eine WVTR von weniger als 0,1 g/(m²*d), bevorzugt weniger als 0,01 g/(m²*d) auf. Ebenso besitzt die Schichtkombination aus Anode 27, diffusionslimitierende Lochinjektionsschicht 31 und Lochtransportschicht als Diffusionsbarriere 35 einen OTR von weniger als 0,1 cm³/(m²*d), bevorzugt weniger als 0,01 cm³/(m²*d) und eine WVTR von als 0,1 g/(m²*d), bevorzugt weniger als 0,01 g/(m²*d) auf.

Durch diese Parameter kann ein Eindringen von Wasser- und Sauerstoffmolekülen in die Emitterschicht 15 verhindert und die Lebensdauer deutlich erhöht werden. Vorteilhafterweise wird hierzu keine aufwendige und teure Barrierefolie benötigt, welche die Gesamtdicke des optoelektronischen Bauelementes 1 vergrößert.

Es wird darauf hingewiesen, dass verschiedene Alternativen zu den beschriebenen Ausführungsformen der Erfindung verwendet werden können, um die Erfindung auszuführen und zu der erfindungsgemäßen Lösung zu gelangen. Das erfindungsgemäße optoelektronische Bauelement und dessen Herstellung in dem beschriebenen Verfahren beschränken sich in ihren Ausführungen somit nicht auf die vorstehenden bevorzugten Ausführungsformen. Vielmehr ist eine Vielzahl von Ausgestaltungsvarianten denkbar, welche von der dargestellten Lösung abweichen können. Ziel der Ansprüche ist es, den Schutzumfang der Erfindung zu definieren.

### Bezugszeichenliste

- 1: optoelektronisches Bauelement
- 2: Licht
- 3: Kathode
- 5: Anode
- 7: Elektroneninjektionsschicht
- 9: Lochinjektionsschicht
- 11: Elektronentransportschicht
- 13: Lochtransportschicht
- 15: Emitterschicht
- 17: Barrierefolie
- 19: diffusionslimitierende Schichten
- 21: Diffusionsbarriere
- 23: Trägersubstrat
- 25: Kathode als Diffusionsbarriere
- 27: Anode als Diffusionsbarriere
- 29: diffusionslimitierende Elektroneninjektionsschicht
- 31: diffusionslimitierende Lochinjektionsschicht
- 33: Elektronentransportschicht als Diffusionsbarriere
- 35: Lochtransportschicht als Diffusionsbarriere

## Patentansprüche

1. Optoelektronisches Bauelement (1) mit einer Kathode (25) und einer Anode (27) und einem Schichtsystem zwischen der Kathode (25) und der Anode (27) umfassend
- mindestens eine kathodennahe Elektroneninjektionsschicht (29) oder
- extraktionsschicht,
- mindestens eine Elektronentransportschicht (33)
- mindestens eine optisch aktive Schicht
- mindestens eine Lochtransportschicht (35)
- mindestens eine anodennahe Lochinjektionsschicht (31) oder - extraktionsschicht
**dadurch gekennzeichnet, dass**
die mindestens eine Elektroneninjektionsschicht (29) oder - extraktionsschicht und die mindestens eine Lochinjektionsschicht (31) oder-extraktionsschicht diffusionslimitierend gegenüber Wasser und Sauerstoff sind und eine Wasserdampftransmissionsrate (WVTR) von weniger als 1 g/(m²*d) und eine Sauerstofftransmissionsrate (OTR) von weniger als 1 cm³/(m²*d) aufweisen und
die mindestens eine Elektronentransportschicht (33) und die mindestens eine Lochtransportschicht (35) eine Diffusionsbarriere gegenüber Wasser und Sauerstoff darstellen und eine Wasserdampftransmissionsrate (WVTR) von weniger als 0,1 g/(m²*d) und eine Sauerstofftransmissionsrate (OTR) von weniger als 0,1 cm³/(m²*d) aufweisen und wobei die mindestens eine Elektronentransportschicht (33) ein dotiertes Metalloxid umfasst,
die mindestens eine Lochtransportschicht (35) ein dotiertes Metallthiocyanat und/oder ein dotiertes Metalloxid umfasst,
die mindestens eine Elektroneninjektionsschicht (29) oder - extraktionsschicht dielektrische Polymere umfasst und
die mindestens eine Lochinjektionsschicht (31) oder-extraktionsschicht dielektrische Polymere umfasst.

2. Optoelektronisches Bauelement (1) gemäß dem vorherigen Anspruch
**dadurch gekennzeichnet, dass**
eine Schichtkombination aus einer Kathode (25), der mindestens einen Elektroneninjektionsschicht (29) oder -extraktionsschicht und der mindestens einen Elektronentransportschicht (33) eine Wasserdampftransmissionsrate (WVTR) von weniger als 0,1 g/(m²*d) und eine Sauerstofftransmissionsrate (OTR) von weniger als 0,1 cm³/(m²*d) aufweist und/oder
eine Schichtkombination aus einer Anode (27), der mindestens einen Lochinjektionsschicht (31) oder -extraktionsschicht und der mindestens einen Elektronentransportschicht (35) eine Wasserdampftransmissionsrate (WVTR) von weniger als 0,1 g/(m²*d) und eine Sauerstofftransmissionsrate (OTR) von weniger als 0,1 cm³/(m²*d) aufweist.

3. Optoelektronisches Bauelement (1) gemäß einem der vorherigen Ansprüche
**dadurch gekennzeichnet, dass**
die mindestens eine Elektronentransportschicht (33) ein dotiertes Zinkoxid umfasst, wobei die Dotierung bevorzugt mit Aluminium, Alkali, Erdalkali, Metallocenen und/oder organischen n-Dotanten erfolgt und die Elektronentransportschicht (33) besonders bevorzugt ein Aluminiumzinkoxid umfasst.

4. Optoelektronisches Bauelement (1) gemäß einem der vorherigen Ansprüche
**dadurch gekennzeichnet, dass**
die mindestens eine Lochtransportschicht (35) ein dotiertes Kupferthiocyanat und/oder ein dotiertes Zinkoxid umfasst,
bevorzugt dotiert mit einem Metallthiocyanat, bevorzugt ausgewählt aus einer Gruppe umfassend Natriumthiocyanat, Kaliumthiocyanat, Silberthiocyanat, Wolframthiocyanat, Vanadiumthiocyanat, Molybdänthiocyanat, Kupferthiocyanat und/oder anderen Übergangsmetallthiocyanaten und/oder bevorzugt dotiert mit einem Metalloxid, bevorzugt ausgewählt aus einer Gruppe umfassend Wolframoxid, Vanadiumoxid, Nickeloxid, Kupferoxid, Molybdänoxid und/oder anderen Übergangsmetalloxiden und/oder bevorzugt dotiert mit einem Halogen, besonders bevorzugt Fluor.

5. Optoelektronisches Bauelement gemäß einem der vorherigen Ansprüche
**dadurch gekennzeichnet, dass**
die mindestens eine Elektronentransportschicht (33) eine Gesamtschichtdicke von 10 - 50 nm bevorzugt 25 - 30 nm aufweist und die mindestens eine Lochtransportschicht (35) eine Gesamtschichtdicke von 10 - 40 nm bevorzugt 10 - 30 nm besonders bevorzugt von 15 - 25 nm aufweist und/oder
die mindestens eine Elektroneninjektionsschicht (29) oder - extraktionsschicht eine Gesamtschichtdicke zwischen 0,1 nm und 10 nm bevorzugt zwischen 5 nm und 7 nm
und die mindestens eine Lochinjektionsschicht oder -extraktionsschicht eine Gesamtschichtdicke zwischen 0,1 nm und 10 nm bevorzugt zwischen 5 nm und 7 nm aufweisen.

6. Optoelektronisches Bauelement (1) gemäß einem der vorherigen Ansprüche
**dadurch gekennzeichnet, dass**
die dielektrische Polymere der mindestens eine Elektroneninjektionsschicht (29) oder -extraktionsschicht hydrophile Polymere und/oder Polyelektrolyte sind, besonders bevorzugt Polymere ausgewählt aus einer Gruppe umfassend Poly-Oxazoline, Polymethacrylate, Polyacrylamide, Polyethylenoxide, Polyacrylsäuren, Polyacrylate, Polyvinylpyrolidon sowie Co-Polymere dieser und ganz besonders bevorzugt Polyvinylalkohol, Polyethylenimin oder ethoxyliertes Polyethylenimin.

7. Optoelektronisches Bauelement (1) gemäß einem der vorherigen Ansprüche
**dadurch gekennzeichnet, dass**
die dielektrische Polymere der mindestens eine Lochinjektionsschicht (31) oder -extraktionsschicht Polymere mit funktionellen Gruppen sind ausgewählt aus eine Gruppe umfassend -CN, -SCN, -F, -Cl, -I und/oder -Br und besonders bevorzugt Polyvinylidenefluorid (PVDF), Polyvinylidenechlorid (PVDC) oder Polyacrylonitril (PAN) sowie Co-Polymere dieser.

8. Optoelektronisches Bauelement (1) gemäß einem der vorherigen Ansprüche
**dadurch gekennzeichnet, dass**
- die mindestens eine Elektronentransportschicht (33) eine Gesamtschichtdicke von 10 - 50 nm. bevorzugt 25 - 30 nm, aufweist,
- die mindestens eine Lochtransportschicht (35) eine Gesamtschichtdicke von 10 - 40 nm, bevorzugt 15 - 25 nm aufweist,
- die mindestens eine Elektroneninjektionsschicht (29) oder - extraktionsschicht eine Gesamtschichtdicke zwischen 0,1 nm und 10 nm, bevorzugt zwischen 5 nm und 7 nm aufweist und
- die Lochinjektionsschicht (31) oder -extraktionsschicht eine Gesamtschichtdicke zwischen 0,1 nm und 10 nm bevorzugt zwischen 5 nm und 7 nm aufweist.

9. Optoelektronisches Bauelement (1) gemäß einem der vorherigen Ansprüche
**dadurch gekennzeichnet, dass**
das Bauelement (1) mindestens zwei Elektroneninjektionsschichten (29) oder -extraktionsschichten, mindestens zwei Elektronentransportschichten (33) , mindestens zwei Lochtransportschichten (35) und mindestens zwei Lochinjektionsschichten (31) oder-extraktionsschichten umfasst,
wobei die Elektroneninjektionsschichten (29) oder -extraktionsschichten und die Elektronentransportschichten (33) sowie die Lochinjektionsschichten (31) oder -extraktionsschichten und die Lochtransportschichten (35) alternierend angeordnet vorliegen.

10. Optoelektronisches Bauelement (1) gemäß einem der vorherigen Ansprüche
**dadurch gekennzeichnet, dass**
die Anode (27) Metalle, Metalloxide, Metallthiocyanate, Metallnanodrähten, Halogene und/oder Mischungen dieser Materialien umfasst, wobei bevorzugt die Metallnanodrähte Silbernanodrähte und/oder Metalloxidnanodrähte sind, die Metalloxide bevorzugt Übergangsmetalloxide, mit Metallen dotierte Metalloxide, besonders bevorzugt Indium-Zinn-Oxid, oder mit Halogenen dotierte Metalloxide, bevorzugt fluoriertes Zinkoxid, sind und die Metallthiocyanate bevorzugt Übergangsmetallthiocyanate, besonders bevorzugt Wolframthiocyanate und/oder Kupferthiocyanate sind und/oder
die Kathode (25) Metalle, Metalloxide, Metallthiocyanate, Metallnanodrähten und/oder Mischungen dieser Materialien umfasst, wobei die Metalle bevorzugt ausgewählt werden aus einer Gruppe umfassend Aluminium, Kupfer, Gallium, Indium, Zinn, Kobalt, Nickel, die Metallnanodrähte bevorzugt Silbernanodrähte und/oder Metalloxidnanodrähte sind und die Kathode besonders bevorzugt mit Metallen dotierte Metalloxide, besonders bevorzugt ein mit Aluminium dotiertes Zinkoxid, umfasst.

11. Optoelektronisches Bauelement (1) gemäß einem der vorherigen Ansprüche
**dadurch gekennzeichnet, dass**
die Anode (27) eine Schichtdicke zwischen 50 und 500 nm besitzt und/oder die Kathode (25) eine Schichtdicke zwischen 50 nm und 500 nm bevorzugt zwischen 100 nm und 200 nm aufweist.

12. Optoelektronisches Bauelement (1) gemäß einem der vorherigen Ansprüche
**dadurch gekennzeichnet, dass**
die optisch aktive Schicht eine Emitterschicht (15) ist mit einem Emissionsspektrum bevorzugt in einem Wellenlängenbereich zwischen 400 nm und 700 nm und/oder
die optisch aktive Schicht eine Absorberschicht ist mit einem Absorptionsspektrum bevorzugt in einem Bereich zwischen 300 nm und 1500 nm.

13. Verfahren zur Herstellung eines optoelektronischen Bauelementes (1) gemäß einem der vorherigen Ansprüche
**dadurch gekennzeichnet, dass**
die Elektroneninjektionsschicht (29), die Elektronentransportschicht (33), die optisch aktive Schicht, die Lochtransportschicht (35) und/oder die Lochinjektionsschicht (31) mit einem nasschemischen Verfahren und/oder einem thermischen Aufdampfverfahren aufgebracht werden, wobei es besonders bevorzugt ist, dass die Schichten durch Siebdruck, Aufschleudern, Offset-Druck, und/oder Gravurdruck und ganz besonders bevorzugt mit Hilfe von einem Tintenstrahldruck-Verfahren und die Kathode und Anode besonders bevorzugt mit einem Aufsprühverfahren aufgebracht werden.

## Claims

1. Optoelectronic component (1) having a cathode (25) and an anode (27) and a layer system between the cathode (25) and the anode (27) comprising
- at least one electron injection layer (29) or electron extraction layer adjacent to the cathode,
- at least one electron transport layer (33)
- at least one optically active layer
- at least one hole transport layer (35)
- at least one hole injection layer (31) or hole extraction layer adjacent to the anode
**characterised in that**
the at least one electron injection layer (29) or electron extraction layer and the at least one hole injection layer (31) or hole extraction layer are diffusion-limiting to water and/or oxygen and have a water vapour transmission rate (WVTR) of less than 1 g/(m²*d) and an oxygen transmission rate (OTR) of less than 1 cm³/(m²*d) and
the at least one electron transport layer (33) and the at least one hole transport layer (35) represent a diffusion barrier against water and/or oxygen and have a water vapour transmission rate (WVTR) of less than 0.1 g/(m²*d) and an oxygen transmission rate (OTR) of less than 0.1 cm³/(m²*d) and wherein
the at east one electron transport layer (33) has a doped metal oxide,
the at least one hole transport layer (35) has a doped metal thiocyanate, and/or a doped metal oxide,
the at least one electron injection layer (29) or electron extraction layer comprises dielectric polymers and
the at least one hole injection layer (31) or hole extraction layer comprises dielectric polymers.

2. Optoelectronic component (1) according to the preceding claim,
**characterised in that**
a layer combination of a cathode (25), the at least one electron injection layer (29) or electron extraction layer and the at least one electron transport layer (33) has a water vapour transmission rate (WVTR) of less than 0.1 g/(m²*d) and an oxygen transmission rate (OTR) of less than 0.1 cm³/(m²*d) and/or
a layer combination of an anode (27), the at least one hole injection layer (31) or hole extraction layer and the at least one electron transport layer (35) has a water vapour transmission rate (WVTR) of less than 0.1 g/(²*d) and an oxygen transmission rate (OTR) of less than 0.1 cm³/(m²*d).

3. Optoelectronic component (1) according to any one of the preceding claims,
**characterised in that**
the at east one electron transport layer (33) has a doted zinc oxide, wherein the doping is preferably carried out with aluminium, alkali, alkaline earth, metallocenes and/or organic n-dopants and the electron transport layer (33) particularly preferably has an aluminium zinc oxide.

4. Optoelectronic component (1) according to any one of the preceding claims,
**characterised in that**
the at least one hole transport layer (35) has a doped copper thiocyanate and/or a doped zinc oxide,
preferably doped with a metal thiocyanate, preferably selected from a group comprising sodium thiocyanate, potassium thiocyanate, silver thiocyanate, tungsten thiocyanate, vanadium thiocyanate, molybdenum thiocyanate, copper thiocyanate and/or other transition metal thiocyanates and/or preferably doped with a metal oxide, preferably selected from a group comprising tungsten oxide, vanadium oxide, nickel oxide, copper oxide, molybdenum oxide and/or other transition metal oxides and/or preferably doped with a halogen, particularly preferably fluorine.

5. Optoelectronic component according to any one of the preceding claims,
**characterised in that**
the at least one electron transport layer (33) has an overall layer thickness of 10 - 50 nm, preferably 25 - 30 nm and the at least one hole transport layer (35) has an overall layer thickness of 10 - 40 nm, preferably 10-30 nm, particularly preferably of 15 - 25 nm
and/or
the at least one electron injection layer (29) or electron extraction layer has an overall layer thickness between 0.1 nm and 10 nm, preferably between 5 nm and 7 nm
and the at least one hole injection layer or hole extraction layer has an overall layer thickness between 0.1 nm and 10 nm, preferably between 5 nm and 7 nm.

6. Optoelectronic component (1) according to any one of the preceding claims,
**characterised in that**
the dielectric polymers of the at least one electron injection layer (29) or electron extraction layer are hydrophilic polymers and/or polyelectrolytes, preferably polymers selected from a group comprising polyoxazolines, polymethacrylates, polyacrylamides, polyethylenoxides, polyacrylic acids, polyacrylates, polyvinylpyrrolidones and copolymers thereof and most particularly preferably polyvinyl alcohol, polyethylenimine or ethoxylated polyethylenimine.

7. Optoelectronic component (1) according to any one of the preceding claims,
**characterised in that**
the dielectric polymers of the at least one hole injection layer (31) or hole extraction layer are polymers with functional groups selected from a group comprising -CN, -SCN, -F, -Cl. -I and/or -Br and particularly preferably polyvinylidene difluoride (PVDF), polyvinylidene chloride (PVDC) or polyacrylonitrile (PAN) and copolymers thereof.

8. Optoelectronic component (1) according to anyone of the preceding claims,
**characterised in that**
- the at least one electron transport layer (33) has an overall layer thickness of 10 - 50 nm, preferably 25 - 30 nm
- the at least one hole transport layer (35) has an overall layer thickness of 10 - 40 nm, preferably of 15 - 25 nm
- the at least one electron injection layer (29) or electron extraction layer has an overall layer thickness between 0.1 nm and 10 nm, preferably between 5 nm and 7 nm and
- the at least one hole injection layer or hole extraction layer has an overall layer thickness between 0.1 nm and 10 nm, preferably between 5 nm and 7 nm.

9. Optoelectronic component (1) according to any one of the preceding claims,
**characterised in that**
the component (1) has at least two electron injection layers (29) or electron extraction layers, at least two electron transport layers (33), at least two hole transport layers (35) and at least two hole injection layers (31) or hole extraction layers,
wherein the electron injection layers (29) or electron extraction layers and the electron transport layers (33) and the hole injection layers (31) or hole extraction layers and the hole transport layers (35) are arranged in an alternating arrangement.

10. Optoelectronic component (1) according to any one of the preceding claims,
**characterised in that**
the anode (27) comprises metals, metal oxides, metal thiocyanates, metal nanowires, halogens and/or mixtures of these metals, wherein preferably the metal nanowires are silver nanowires and/or metal oxide nanowires, the metal oxides are preferably transition metal oxides, with metal-doped metal oxides, particularly preferably indium tin oxide, or with halogen-doped metal oxides, preferably fluorinated zinc oxide and the metal thiocyanates are preferably transition metal thiocyanates, particularly preferably tungsten thiocyanates and/or copper thiocyanates and/or
the cathode (25) comprises metals, metal oxides, metal thiocyanates, metal nanowires and/or mixtures of these materials, wherein the metals are preferably selected from a group comprising aluminium, copper, gallium, indium, tin, cobalt, nickel, the metal nanowires are preferably silver nanowires and/or metal oxide nanowires and the cathode particularly preferably comprises metal oxides doped with metals, particularly preferably a zinc oxide doped with aluminium.

11. Optoelectronic component (1) according to any one of the preceding claims,
**characterised in that**
the anode (27) has a layer thickness between 50 and 500 nm and/or
the cathode (25) has a layer thickness between 50 nm and 500 nm, preferably between 100 nm and 200 nm.

12. Optoelectronic component (1) according to any one of the preceding claims,
**characterised in that**
the optically active layer is an emitter layer (15) with an emission spectrum preferably in a wavelength range between 400 nm and 700 nm and/or
the optically active layer is an absorber layer with an absorption spectrum preferably in a range between 300 nm and 1500 nm.

13. Method for producing an optoelectronic component (1) according to any one of the preceding claims,
**characterised in that**
the electron injection layer (29), the electron transport layer (33), the optically active layer, the hole transport layer (35) and/or the hole injection layer (31) are applied with a wet chemical method and/or a thermal evaporation method, wherein it is particularly preferable that the layers are applied by screen printing, spin coating, offset printing, and/or gravure printing, and particularly preferably by means of an ink jet printing method, and the cathode and anode are particularly preferably applied with a spraying method.

## Revendications

1. Composant optoélectronique (1) ayant une cathode (25) et une anode (27) et un système de couches entre la cathode (25) et l'anode (27) qui comprend
- au moins une couche d'injection (29) ou d'extraction d'électrons à proximité de la cathode,
- au moins une couche de transport d'électrons (33)
- au moins une couche optiquement active
- au moins une couche de transport de trous (35)
- au moins une couche d'injection (31) ou d'extraction de trous à proximité de l'anode
**caractérisé en ce que**
l'au moins une couche d'injection (29) ou d'extraction d'électrons et l'au moins une couche d'injection (31) ou d'extraction de trous limitent la diffusion de l'eau et de l'oxygène et ont un taux de transmission de vapeur d'eau (WVTR) inférieur à 1 g/(m²*d) et un taux de transmission d'oxygène (OTR) inférieur à 1 cm³/(m²*d) et
l'au moins une couche de transport d'électrons (33) et l'au moins une couche de transport de trous (35) représentent une barrière de diffusion de l'eau et de l'oxygène et ont un taux de transmission de vapeur d'eau (WVTR) inférieur à 0,1 g/(m²*d) et un taux de transmission d'oxygène (OTR) inférieur à 0,1 cm³/(m²*d) et dans lequel l'au moins une couche de transport d'électrons (33) comprend un oxyde métallique dopé,
l'au moins une couche de transport de trous (35) comprend un thiocyanate métallique dopé et/ou un oxyde métallique dopé, l'au moins une couche d'injection (29) ou d'extraction d'électrons comprend des polymères diélectriques et
l'au moins une couche d'injection (31) ou d'extraction de trous comprend des polymères diélectriques.

2. Composant optoélectronique (1) selon la revendication précédente
**caractérisé en ce que**
une combinaison de couches d'une cathode (25), de l'au moins une couche d'injection (29) ou d'extraction d'électrons et de l'au moins une couche de transport d'électrons (33), a un taux de transmission de vapeur d'eau (WVTR) inférieur à 0,1 g/(m²*d) et un taux de transmission d'oxygène (OTR) inférieur à 0,1 cm³/(m²*d) et/ou
une combinaison de couches d'une anode (27), de l'au moins une couche d'injection (31) ou d'extraction de trous et de l'au moins une couche de transport d'électrons (35), a un taux de transmission de vapeur d'eau (WVTR) inférieur à 0,1 g/(m²*d) et un taux de transmission d'oxygène (OTR) inférieur à 0,1 cm³/(m²*d).

3. Composant optoélectronique (1) selon l'une des revendications précédentes
**caractérisé en ce que**
l'au moins une couche de transport d'électrons (33) comprend un oxyde de zinc dopé, dans lequel le dopage est de préférence obtenu avec de l'aluminium, de l'alcali, des métaux alcalinoterreux, des métallocènes et/ou des n-dopants organiques et la couche de transport d'électrons (33) comprend de manière particulièrement préférée un oxyde de zinc d'aluminium.

4. Composant optoélectronique (1) selon l'une des revendications précédentes
**caractérisé en ce que**
l'au moins une couche de transport de trous (35) comprend un thiocyanate de cuivre dopé et/ou un oxyde de zinc dopé, de préférence dopé avec un thiocyanate métallique, de préférence choisi dans un groupe comprenant du thiocyanate de sodium, du thiocyanate de potassium, du thiocyanate d'argent, du thiocyanate de tungstène, du thiocyanate de vanadium, du thiocyanate de molybdène, du thiocyanate de cuivre et/ou d'autres thiocyanates métalliques de transition et/ou de préférence dopé avec un oxyde métallique, de préférence choisi dans un groupe comprenant de l'oxyde de tungstène, de l'oxyde de vanadium, de l'oxyde de nickel, de l'oxyde de cuivre, de l'oxyde de molybdène et/ou d'autres oxydes métalliques de transition et/ou de préférence dopé avec un halogène, de manière particulièrement préférée le fluor.

5. Composant optoélectronique selon l'une des revendications précédentes
**caractérisé en ce que**
l'au moins une couche de transport d'électrons (33) a une épaisseur totale de couche de 10 à 50 nm, de préférence de 25 à 30 nm et l'au moins une couche de transport de trous (35) a une épaisseur totale de couche de 10 à 40 nm, de préférence de 10 à 30 nm, de manière particulièrement préférée de 15 à 25 m et/ou
l'au moins une couche d'injection (29) ou d'extraction d'électrons a une épaisseur totale de couche comprise entre 0,1 nm et 10 nm, de préférence entre 5 nm et 7 nm et l'au moins une couche d'injection ou d'extraction d'électrons a une épaisseur totale de couche comprise entre 0,1 nm et 10 nm, de préférence entre 5 nm et 7 nm.

6. Composant optoélectronique (1) selon l'une des revendications précédentes
**caractérisé en ce que**
les polymères diélectriques de l'au moins une couche d'injection (29) ou d'extraction d'électrons sont des polymères hydrophiles et/ou des polyélectrolytes, de manière particulièrement préférée des polymères choisis dans un groupe comprenant des polyoxazolines, des polyméthacrylates, des polyacrylamides, des oxydes de polyéthylène, des acides polyacryliques, des polyacrylates, de la polyvinylpyrrolidone et leurs copolymères et tout particulièrement de préférence de l'alcool polyvinylique, de la polyéthylèneimine ou de la polyéthylèneimine éthoxylée.

7. Composant optoélectronique (1) selon l'une des revendications précédentes
**caractérisé en ce que**
les polymères diélectriques de l'au moins une couche d'injection (31) ou d'extraction de trous sont des polymères ayant des groupes fonctionnels choisis dans un groupe comprenant du CN, du SCN, du F, du CI, du I et/ou du Br et de manière particulièrement préférée du fluorure de polyvinylidène (PVDF), du chlorure de polyvinylidène (PVDC) ou du polyacrylonitrile (PAN) et leurs copolymères.

8. Composant optoélectronique (1) selon l'une des revendications précédentes
**caractérisé en ce que**
- l'au moins une couche de transport d'électrons (33) a une épaisseur totale de couche de 10 à 50 nm, de préférence de 25 à 30 nm,
- l'au moins une couche de transport de trous (35) a une épaisseur totale de couche de 10 à 40 nm, de préférence de 15 à 25 nm,
- l'au moins une couche d'injection (29) ou d'extraction d'électrons a une épaisseur totale de couche comprise entre 0,1 nm et 10 nm, de préférence entre 5 nm et 7 nm et
- la couche d'injection (31) ou d'extraction de trous a une épaisseur totale de couche comprise entre 0,1 nm et 10 nm, de préférence entre 5 nm et 7 nm.

9. Composant optoélectronique (1) selon l'une des revendications précédentes
**caractérisé en ce que**
le composant (1) comprend au moins deux couches d'injection (29) ou d'extraction d'électrons, au moins deux couches de transport d'électrons (33), au moins deux couches de transport de trous (35) et au moins deux couches d'injection (31) ou d'extraction de trous, dans lequel les couches d'injection (29) ou d'extraction d'électrons et les couches de transport d'électrons (33) ainsi que les couches d'injection (31) ou d'extraction de trous et les couches de transport de trous (35) sont disposées en alternance.

10. Composant optoélectronique (1) selon l'une des revendications précédentes
**caractérisé en ce que**
l'anode (27) comprend des métaux, des oxydes métalliques, des thiocyanates métalliques, des nanofils métalliques, des halogènes et/ou leurs mélanges, dans lequel les nanofils métalliques sont de préférence des nanofils d'argent et/ou des nanofils d'oxydes métalliques, les oxydes métalliques sont de préférence des oxydes de métaux de transition, des oxydes métalliques dopés avec des métaux, de manière particulièrement préférée de l'oxyde d'indium-étain, ou de l'oxyde métallique dopé avec des halogènes, de préférence de l'oxyde de zinc fluoré, et les thiocyanates métalliques sont de préférence des thiocyanates de métaux de transition, de manière particulièrement préférée des thiocyanates de tungstène et/ou des thiocyanates de cuivre et/ou
la cathode (25) comprend des métaux, des oxydes métalliques, des thiocyanates métalliques, des nanofils métalliques et/ou leurs mélanges, dans lequel les métaux sont de préférence choisis dans un groupe comprenant de l'aluminium, du cuivre, du gallium, de l'indium, de l'étain, du cobalt, du nickel, les nanofils métalliques de préférence des nanofils d'argent et/ou des nanofils d'oxyde métallique et la cathode comprend de manière particulièrement préférée des oxydes métalliques dopés avec des métaux, de manière particulièrement préférée un oxyde de zinc dopé avec de l'aluminium.

11. Composant optoélectronique (1) selon l'une des revendications précédentes
**caractérisé en ce que**
l'anode (27) a une épaisseur de couche comprise entre 50 et 500 nm et/ou
la cathode (25) a une épaisseur de couche comprise entre 50 nm et 500 nm, de préférence entre 100 nm et 200 nm.

12. Composant optoélectronique (1) selon l'une des revendications précédentes
**caractérisé en ce que**
la couche optiquement active est une couche émettrice (15) avec un spectre d'émission de préférence dans une plage de longueur d'onde comprise entre 400 nm et 700 nm et/ou
la couche optiquement active est une couche absorbante avec un spectre d'absorption de préférence dans une plage de longueur d'onde comprise entre 300 nm et 1500 nm.

13. Procédé de production d'un composant optoélectronique (1) selon l'une des revendications précédentes
**caractérisé en ce que**
la couche d'injection d'électrons (29), la couche de transport d'électrons (33), la couche optiquement active, la couche de transport de trous (35) et/ou la couche d'injection de trous (31) sont appliquées au moyen d'un procédé chimique humide et/ou d'un procédé d'évaporation thermique, dans lequel il est particulièrement préféré que les couches soient appliquées par sérigraphie, par centrifugation, par impression offset et/ou impression sur gravure et de manière tout particulièrement préférée à l'aide d'un procédé d'impression à jet d'encre, et la cathode et l'anode sont de manière particulièrement préférée appliqué avec un procédé de pulvérisation.
